# EUROPEAN PATENT APPLICATION

(11) **EP 4 678 682 A1**
(43) Date of publication of application: **14.01.2026**
(21) Application number: 24767004.5
(22) Date of filing: 29.02.2024
(51) Int. Cl.: C08G 75/0236, H05K 1/03

(54) **PHENYLENE SULFIDE-PHENYLENE OXIDE COPOLYMER**

(30) Priority: 07.03.2023 JP 2023034440
(71) Applicant: Daicel Corporation, Osaka-shi, Osaka 530-0011 (JP); WASEDA UNIVERSITY, Shinjuku-ku Tokyo 169-8050 (JP)
(72) Inventor: ISHIKAWA, Shinsuke, Tokyo 108-8230 (JP); INOUE, Keizo, Tokyo 108-8230 (JP); ITO, Daisuke, Tokyo 108-8230 (JP); OYAIZU, Kenichi, Tokyo 169-8050 (JP)
(74) Representative: Grünecker Patent- und Rechtsanwälte PartG mbB
(86) International application number: PCT/JP2024/007495
(87) International publication number: WO 2024/185634

(57) **Abstract**

Provided is a resin having a low dielectric loss tangent. A phenylene sulfide-phenylene oxide copolymer for a wiring board includes a constituent unit represented by Formula (I):

-Ph¹-O-Ph²-S- (I)

where Ph¹ and Ph² each independently represent a phenylene group optionally having a substituent. At least one of Ph¹ and Ph² preferably has one or more substituents.

## Description

### Technical Field

The present disclosure relates to a phenylene sulfide-phenylene oxide copolymer.

### Background Art

In recent years, high-speed and large-capacity mobile communication systems have been developed. With the progress of such mobile communication systems, higher frequency bands have been used for communication. For example, in a fifth generation mobile communication system which has already started to be put into practical use, a frequency band higher than that of a fourth generation or earlier mobile communication system is used.

In a terminal of a mobile communication system, attenuation of an electric signal through a circuit of a printed wiring board, a so-called transmission loss, occurs. The transmission loss depends also on dielectric characteristics of a board (dielectric) of the printed wiring board. In general, a higher frequency used has a greater influence on dielectric loss tangent and causes a greater transmission loss.

Suppression of a transmission loss in a printed wiring board used for communication in a high frequency band is required for enabling higher-speed mobile communication. Therefore, a low transmission loss is also required of a resin or resin composition serving as a material for a printed wiring board. A resin or resin composition having a low dielectric loss tangent is required for ensuring a low transmission loss.

Resin compositions containing a polyphenylene ether (PPO) resin (for example, Patent Document 1) or a polyphenylene sulfide (PPS) resin (for example, Patent Documents 2 and 3) as a main component have been widely used as materials for wiring boards such as printed wiring boards.

Patent Document 1: JP 2005-60635 A
Patent Document 2: JP 2002-225029 A
Patent Document 3: JP H05-98157 A

### Summary of Invention

However, the PPO resin itself has low flame retardancy, and thus there is a problem that it is necessary to impart flame retardancy to the resin composition by mixing it with a flame retardant material to use it as a material for a wiring board. In addition, an unsubstituted PPS resin has a high dielectric loss tangent, and thus has a problem that the transmission loss also increases in communication applications in a high frequency band.

The present disclosure is directed to provide a resin having a low dielectric loss tangent.

The present disclosure includes the following aspects.

### <First Aspect>

[1] A phenylene sulfide-phenylene oxide copolymer for a wiring board, the phenylene sulfide-phenylene oxide copolymer including
   a constituent unit represented by Formula (I):

      -Ph¹-O-Ph²-S- (I)
   where Ph¹ and Ph² each independently represent a phenylene group optionally having a substituent.
[2] The phenylene sulfide-phenylene oxide copolymer according to [1], wherein in Formula (I), at least one of Ph¹ and Ph² has one or more substituents.
[3] The phenylene sulfide-phenylene oxide copolymer according to [1] or [2], wherein the constituent unit represented by Formula (I) includes a constituent unit represented by Formula (II): 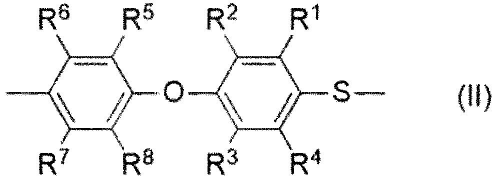 where
   R¹, R², R³, R⁴, R⁵, R⁶, R⁷, and R⁸ are each independently H, an alkyl group, an alkoxy group, an alkenyl group, or an aryl group,
   one or more of R¹, R², R³, and R⁴ are an alkyl group, an alkoxy group, an alkenyl group, or an aryl group, and/or
   one or more of R⁵, R⁶, R⁷, and R⁸ are an alkyl group, an alkoxy group, an alkenyl group, or an aryl group.
[4] The phenylene sulfide-phenylene oxide copolymer according to [3], wherein
   in Formula (II),
   one or more of R¹, R², R³, and R⁴ are an alkyl group, an alkoxy group, an alkenyl group, or an aryl group, and
   one or more of R⁵, R⁶, R⁷, and R⁸ are an alkyl group, an alkoxy group, an alkenyl group, or an aryl group.
[5] The phenylene sulfide-phenylene oxide copolymer according to any one of [1] to [3], wherein a content of the constituent unit represented by Formula (I) is 60 mol% or more with respect to all constituent units.
[6] The phenylene sulfide-phenylene oxide copolymer according to any one of [1] to [5], wherein a dielectric loss tangent at 10 GHz of the phenylene sulfide-phenylene oxide copolymer is less than 0.002.
[7] The phenylene sulfide-phenylene oxide copolymer according to any one of [1] to [6], wherein a dielectric loss tangent at 80 GHz of the phenylene sulfide-phenylene oxide copolymer is less than 0.002.
[8] The phenylene sulfide-phenylene oxide copolymer according to any one of [1] to [7], wherein a ratio tan δ₈₀/tan δ₁₀ of the dielectric loss tangent tan δ₈₀ at 80 GHz to the dielectric loss tangent tan δ₁₀ at 10 GHz is 1.5 or less.
[9] A resin composition including the phenylene sulfide-phenylene oxide copolymer described in any one of [1] to [8].
[10] A wiring board containing the phenylene sulfide-phenylene oxide copolymer described in any one of [1] to [8] or the resin composition described in [9].
[11] A printed wiring board including:
   the wiring board described in [10]; and
   an electronic component.
[12] A wiring board material including the phenylene sulfide-phenylene oxide copolymer described in any one of [1] to [8] or the resin composition described in [9].
[13] The wiring board material according to [12], being a varnish, an interlayer insulating material, a prepreg, a metal-clad laminate, or a substrate.
[14] A compatibilizer including the phenylene sulfide-phenylene oxide copolymer described in any one of [1] to [8] or the resin composition described in [9].
[15] The compatibilizer according to [14], being for a resin composition containing a polyarylene sulfide resin and a polyarylene ether resin.

### <Second Aspect>

(10) A phenylene sulfide-phenylene oxide copolymer, including
   a constituent unit represented by Formula (Ia):

      -Ph^{1a}-O-Ph^{2a}-S- (Ia)
   where
   Ph^{1a} and Ph^{2a} each independently represent a phenylene group optionally having a substituent, and
   Ph^{1a} and Ph^{2a} each have one or more substituents.
(11) The phenylene sulfide-phenylene oxide copolymer according to (10), wherein the constituent unit represented by Formula (Ia) includes a constituent unit represented by Formula (IIa): 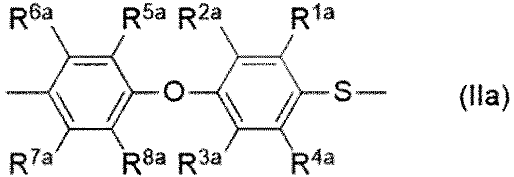 where
   R^{1a}, R^{2a}, R^{3a}, R^{4a}, R^{5a}, R^{6a}, R^{7a} and R^{8a} are each independently H, an alkyl group, an alkoxy group, an alkenyl group, or an aryl group,
   one or more of R^{1a}, R^{2a}, R^{3a}, and R^{4a} are an alkyl group, an alkoxy group, an alkenyl group, or an aryl group, and
   one or more of R^{5a}, R^{6a}, R^{7a}, and R^{8a} are an alkyl group, an alkoxy group, an alkenyl group, or an aryl group.
(12) The phenylene sulfide-phenylene oxide copolymer according to (11), wherein
   in Formula (IIa),
   R^{2a}, R^{3a}, R^{6a}, and R^{7a} are each independently an alkyl group, an alkoxy group, an alkenyl group, or an aryl group, or
   R^{1a}, R^{4a}, R^{5a}, and R^{8a} are each independently an alkyl group, an alkoxy group, an alkenyl group, or an aryl group.
(13) The phenylene sulfide-phenylene oxide copolymer according to (10) or (11), wherein a content of the constituent unit represented by Formula (Ia) is 60 mol% or more with respect to all constituent units.
(14) The phenylene sulfide-phenylene oxide copolymer according to any one of (10) to (13), wherein a ratio tan δ₈₀/tan δ₁₀ of a dielectric loss tangent tan δ₈₀ at 80 GHz to a dielectric loss tangent tan δ₁₀ at 10 GHz of the phenylene sulfide-phenylene oxide copolymer is 1.5 or less.
(15) A resin composition containing the phenylene sulfide-phenylene oxide copolymer described in any one of (10) to (14).
(16) A wiring board including the phenylene sulfide-phenylene oxide copolymer described in any one of (10) to (14) or the resin composition described in (15).
(17) A printed wiring board including:
   the wiring board described in (16); and
   an electronic component.
(18) A wiring board material including the phenylene sulfide-phenylene oxide copolymer described in any one of (10) to (14) or the resin composition described in (15).
(19) The wiring board material according to (18), being a varnish, an interlayer insulating material, a prepreg, a metal-clad laminate, or a substrate.
(20) A compatibilizer including the phenylene sulfide-phenylene oxide copolymer described in any one of (10) to (14) or the resin composition described in (15).
(21) The compatibilizer according to (20), being for a resin composition containing a polyarylene sulfide resin and a polyarylene ether resin.

According to an embodiment of the present disclosure, it is possible to provide a resin having a low dielectric loss tangent.

### Brief Description of Drawings

FIG. 1(a) is a ¹H-NMR (CD₂Cl₂) chart of a monomer (3',5'-3,5-DPS) obtained in Synthesis Example 1. FIG. 1(b) is a ¹H-NMR (CD₂Cl₂) chart of PMPS-PPO-1 obtained in Example 1.
FIG. 2(a) is a ¹³C-NMR (CDCl₃) chart of the monomer (3',5'-3,5-DPS) obtained in Synthesis Example 1. FIG. 2(b) is a ¹³C-NMR (CDCl₃) chart of PMPS-PPO-1 obtained in Example 1.
FIG. 3 is a graph of a dielectric loss tangent at each frequency.

### Description of Embodiments

Hereinafter, an embodiment of the present disclosure will be described in detail. The present disclosure is not limited to the following embodiment, and can be carried out by making appropriate changes within a range that does not impair the effects of the present disclosure. Configuration, a combination of them, and the like in embodiments are examples, and an addition, an omission, a substitution, and another change of the configuration can be appropriately made without departing from the spirit of the present disclosure. The present disclosure is not limited by the embodiments and is limited only by the claims. Each aspect disclosed in the present description can be combined with another feature disclosed in the present description. Where a particular description given for an embodiment also applies to another embodiment, that description may be omitted in the other embodiment. In the present disclosure, the expression "from X to Y" with regard to a numerical range means "X or more and Y or less".

### <First Embodiment>

### [Phenylene Sulfide-Phenylene Oxide Copolymer (P1) for Wiring Board]

A phenylene sulfide-phenylene oxide copolymer (P1) according to a first embodiment is a phenylene sulfide-phenylene oxide copolymer for a wiring board, and includes a constituent unit represented by Formula (I):

-Ph¹-O-Ph²-S- (I)

where Ph¹ and Ph² each independently represent a phenylene group optionally having a substituent. In one embodiment, at least one of Ph¹ and Ph² preferably has one or more substituents.

As used herein, the "phenylene sulfide-phenylene oxide copolymer" means a polymer having a phenylene sulfide structure (-Ph-S-) and a phenylene oxide structure (-Ph-O-) in one constituent unit (Ph represents a phenylene group). A polymer having a phenylene sulfide structure and a phenylene oxide structure alternately in the molecule may be referred to as a "phenylene sulfide-phenylene oxide alternating copolymer". The "phenylene sulfide-phenylene oxide copolymer" can be produced, for example, by subjecting a disulfide monomer having a phenylene oxide skeleton to oxidative polymerization. A production method thereof will be described below.

When the constituent unit represented by Formula (I) is included, the phenylene sulfide-phenylene oxide copolymer (P1) can achieve a low dielectric loss tangent. In addition, in Formula (I), when at least one phenylene group has one or more substituents, a low dielectric loss tangent is more easily achieved. Although the mechanism of these is not clear at this stage, it is possible that, as a non-limiting mechanism, the presence of the phenylene sulfide structure and the phenylene oxide structure makes a plane angle of the phenylene group not constant, and thus dense packing is suppressed, thereby lowering the dielectric loss tangent. Further, in a case where at least one phenylene group has one or more substituents, it is possible that a twist angle of the phenylene group becomes less likely to move, and thus the molecular chain becomes less likely to move, which makes the dielectric loss tangent more likely to be lowered.

The phenylene sulfide-phenylene oxide copolymer (P1) has a low dielectric loss tangent and thus can be suitably used as a material for a wiring board. As an additional characteristic, the phenylene sulfide-phenylene oxide copolymer (P1) is less likely to have a higher dielectric loss tangent even at a higher frequency band. In this case, it is not necessary to change the design of the wiring board material for each frequency, and versatility is high, whereby the wiring board can be produced more efficiently and economically.

### (For Wiring Board)

In the present description, the "wiring board" "for a wiring board" includes all portions other than an electronic component such as a semiconductor chip in a printed wiring board (also referred to as printed circuit board). In general, the printed wiring board has a structure in which a semiconductor package including an electronic component such as a semiconductor chip mounted on a pedestal called a substrate is mounted on a print circuit board (PCB), but the "board" "for a wiring board" also includes a substrate.

Thus, the phrase "for a wiring board" means that the phenylene sulfide-phenylene oxide copolymer is used as a material for a wiring board, which is used to be attached with an electronic component such as a semiconductor chip and to be provided with wiring.

The phenylene sulfide-phenylene oxide copolymer (P1) for a wiring board according to the present embodiment includes the constituent unit represented by Formula (I), and thus is suitably used as a material for a wiring board because of its property of having a low dielectric loss tangent. Various applications will be described below.

### (Phenylene Sulfide-Phenylene Oxide Copolymer (P1))

The phenylene sulfide-phenylene oxide copolymer (P1) includes a constituent unit represented by Formula (I):

-Ph¹-O-Ph²-S- (I)

where Ph¹ and Ph² each independently represent a phenylene group optionally having a substituent.

As used herein, the phrase "phenylene group optionally having a substituent" means a substituted or unsubstituted phenylene group.

In one embodiment, at least one of Ph¹ and Ph² preferably has one or more substituents. The phrase "has one or more substituents" means that one or more hydrogen atoms constituting the phenylene group are substituted with an atom other than hydrogen or an atomic group.

In Formula (I), in a case where both of Ph¹ and Ph² have a substituent, types of substituents that Ph¹ and Ph² have may be the same or different from each other. The numbers and the substitution positions of the substituents in Ph¹ and Ph² may be the same or different from each other. In an embodiment, at least one of Ph¹ or Ph² (preferably both of them) preferably has one or more substituents, and more preferably two or more substituents, and may have three or four substituents.

In an embodiment, Ph¹ can have one or more substituents, can have two or more substituents, and can have three or four substituents. In an embodiment, Ph¹ can have two substituents. In a case where Ph¹ has two or more substituents, types of the substituents may be the same or different from each other.

In an embodiment, Ph² can have one or more substituents, can have two or more substituents, and can have three or four substituents. In an embodiment, Ph² can have two substituents. In a case where Ph² has two or more substituents, types of the substituents may be the same or different from each other.

In an embodiment, as an additional effect, from the viewpoint of easily obtaining an additional characteristic of the dielectric loss tangent being less likely to be higher even at a higher frequency, both of Ph¹ and Ph² preferably have one or more substituents, more preferably have two or more substituents, and may have three or four substituents. In an embodiment, both Ph¹ and Ph² can have one or two substituents.

Examples of the substituent include a hydroxy group (-OH), a carboxy group, an amino group, a cyano group (-CN), a nitro group (-NO₂), a thiol group, a sulfo group (-SO₃H), an alkyl group, an alkenyl group, an acyl group, an alkynyl group, an alkoxy group, an aryl group, and a heteroaromatic group. Among these, the substituent is preferably one or more selected from the group consisting of an alkyl group, an alkoxy group, an alkenyl group, and an aryl group, from the viewpoint of easily realizing a low dielectric loss tangent. Examples of the carboxy group include carboxy groups having from 1 to 10 carbons. Examples of the amino group include groups represented by -NH₂, - NHR¹¹, or -NR¹²R¹³ (R¹¹, R¹², and R¹³ each independently represent an alkyl group having from 1 to 10 carbons). Examples of the thiol group include groups represented by -R¹⁴-SH (R¹⁴ represents an alkyl group having from 1 to 10 carbons). Examples of the acyl group include groups represented by R²⁰C(=O)- (R²⁰ represents an alkyl group having from 1 to 10 carbons). Examples of the alkynyl group include an alkynyl group having from 2 to 10 carbons (for example, an ethynyl group, a propargyl group, and the like). Examples of the heteroaromatic group include a furan ring, a benzofuran ring, a dibenzofuran ring, a thiophene ring, and a benzothiophene ring.

Examples of the alkyl group include linear, branched, or cyclic alkyl groups having from 1 to 10 carbons (preferably from 1 to 5 carbons, and more preferably from 1 to 3 carbons, for example, 1 carbon or 2 carbons). Examples of the linear, branched, or cyclic alkyl group having from 1 to 10 carbons include a methyl group, an ethyl group, an n-propyl group, an isopropyl group, an n-butyl group, a tert-butyl group, an s-isobutyl group, an n-pentyl group, an isopentyl group, a neopentyl group, an n-hexyl group, an isohexyl group, an n-heptyl group, an n-octyl group, an isooctyl group, an n-nonyl group, an isononyl group, an n-decyl group, an isodecyl group, a cyclopropyl group, a cyclobutyl group, a cyclopentyl group, a cyclohexyl group, a cycloheptyl group, and a cyclooctyl group.

In one embodiment, the alkyl group is preferably a methyl group, an ethyl group, and/or an isopropyl group.

Examples of the alkoxy group include linear, branched, or cyclic alkoxy groups having from 1 to 10 carbons (preferably from 1 to 5 carbons, and more preferably from 1 to 3 carbons, for example, 1 carbon or 2 carbons). Examples of the linear, branched, or cyclic alkoxy group having from 1 to 10 carbons include a methoxy group, an ethoxy group, an n-propoxy group, an isopropoxy group, an n-butoxy group, a tert-butoxy group, an s-butoxy group, an isobutoxy group, an n-pentyloxy group, an isopentyloxy group, a neopentyloxy group, an n-hexyloxy group, an isohexyloxy group, an s-hexyloxy group, a tert-hexyloxy group, a neohexyloxy group, an n-heptyloxy group, an n-octyloxy group, an isooctyloxy group, an n-nonyloxy group, an isononyloxy group, an n-decyloxy group, an isodecyloxy group, a cyclopropoxy group, a cyclobutoxy group, a cyclopentyloxy group, a cyclohexyloxy group, a cycloheptyloxy group, a cyclooctyloxy group, a cyclononyloxy group, and a cyclodecyloxy group.

In one embodiment, the alkoxy group is preferably a methoxy group and/or an ethoxy group.

Examples of the alkenyl group include linear, branched, or cyclic alkenyl groups having from 2 to 10 carbons (preferably from 2 to 5 carbons, and more preferably from 2 to 3 carbons). Examples of the linear, branched, or cyclic alkenyl group having from 2 to 10 carbons include a substituent containing one or more carbon-carbon double bonds in the chain of an alkyl group having 2 or more carbons, and specific examples thereof include a vinyl group, an allyl group, a 1-propenyl group, an isopropenyl group, a 3-butenyl group, a 2-butenyl group, a 1-butenyl group, a 1,3-butadienyl group, a 4-pentenyl group, a 3-pentenyl group, a 2-pentenyl group, a 1-pentenyl group, a 1,3-pentadienyl group, a 2,4-pentadienyl group, a 1,1-dimethyl-2-propenyl group, a 1-ethyl-2-propenyl group, a 1,2-dimethyl-1-propenyl group, a 1-methyl-1-butenyl group, a 5-hexenyl group, a 4-hexenyl group, a 2-hexenyl group, a 1-hexenyl group, a 1-methyl-1-hexenyl group, a 2-methyl-2-hexenyl group, a 3-methyl-1,3-hexadienyl group, a 1-heptenyl group, a 2-octenyl group, a 3-nonenyl group, a 4-decenyl group, a cyclopropenyl group, a cyclobutenyl group, a cyclopentenyl group, a cyclohexenyl group, a cycloheptenyl group, a cyclooctenyl group, a cyclononenyl group, and a cyclodecenyl group.

In one embodiment, the alkenyl group is preferably a vinyl group, and/or an allyl group.

Examples of the aryl group include aryl groups having from 6 to 12 carbons, and specific examples thereof include a phenyl group and a naphthyl group. In one embodiment, the aryl group is preferably a phenyl group.

In consideration of ease of synthesis of the phenylene sulfide-phenylene oxide copolymer (P1), one or more substituents that at least one of Ph¹ and Ph² in Formula (I) may have are preferably selected from alkyl groups and alkenyl groups, are preferably selected from alkyl groups having from 1 to 10 carbons and alkenyl groups having from 2 to 10 carbons, are more preferably selected from linear alkyl groups having from 1 to 4 carbons and linear alkenyl groups having 2 to 5 carbons, still more preferably include an ethyl group, a methyl group, a vinyl group, and/or an allyl group, and even still more preferably include a methyl group.

The position of the substituent in Ph¹ may be any of the 2-position, the 3-position, the 5-position, and the 6-position. In a case where Ph¹ has two substituents, the positions of the substituents therein may be the 2- and 3-positions (or the 5- and 6-positions), the 2- and 5-positions (or the 3- and 6-positions), the 2- and 6-positions, or the 3- and 5-positions. In a case where the Ph¹ has three substituents, the positions of the substituents therein may be either the 2-,3-, and 5-positions (or the 3-, 5-, and 6-positions) or the 2-, 3-, and 6-positions (or the 2-, 5-, and 6-positions).

The position of the substituent in Ph² may be any of the 2-position, the 3-position, the 5-position, and the 6-position. In a case where Ph² has two substituents, the positions of the substituents therein may be the 2- and 3-positions (or the 5- and 6-positions), the 2- and 5-positions (or the 3- and 6-positions), the 2- and 6-positions, or the 3- and 5-positions. In a case where the Ph² has three substituents, the positions of the substituents therein may be either the 2-, 3-, and 5 positions (or the 3-, 5-, and 6-positions) or the 2-, 3-, and 6-positions (or the 2-, 5-, and 6-positions).

In one embodiment, in a case where either one of Ph¹ and Ph² has two substituents, Ph¹ may have, at the 3- and 5-positions, two substituents selected from the group consisting of an alkyl group, an alkoxy group, an alkenyl group, and an aryl group, or Ph² may have, at the 3- and 5-positions, two substituents selected from the group consisting of an alkyl group, an alkoxy group, an alkenyl group, and an aryl group.

As described above, in the case where both Ph¹ and Ph² have substituents, the substitution positions may be the same or different from each other. In a case where two or more substituents are included in each of Ph¹ and Ph², the combination of the substitution positions is not limited.

In one embodiment, in the case where both Ph¹ and Ph² have two substituents, the substitution positions may be at the 3- and 5-positions for both. In one embodiment, in the case where both Ph¹ and Ph² have two substituents, both may have, at the 3- and 5-positions, two substituents selected from the group consisting of an alkyl group, an alkoxy group, an alkenyl group, and an aryl group.

In one embodiment, in the case where both Ph¹ and Ph² have two substituents, the substitution positions in one of them (for example, Ph¹) may be the 3- and 5-positions, and the substitution positions in the other (for example, Ph²) may be the 2- and 6-positions. In one embodiment, in the case where both Ph¹ and Ph² have two substituents, one of them (for example, Ph¹) may have, at the 3- and 5-positions, two substituents selected from the group consisting of an alkyl group, an alkoxy group, an alkenyl group, and an aryl group, and the other (for example, Ph²) may have, at the 2- and 6-positions, two substituents selected from the group consisting of an alkyl group, an alkoxy group, an alkenyl group, and an aryl group.

In one embodiment, the constituent unit represented by Formula (I) preferably includes a constituent unit represented by Formula (II): 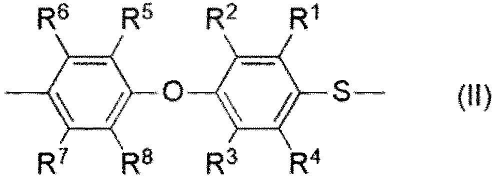 where
R¹, R², R³, R⁴, R⁵, R⁶, R⁷, and R⁸ are each independently H, an alkyl group, an alkoxy group, an alkenyl group, or an aryl group,
one or more of R¹, R², R³, and R⁴ are an alkyl group, an alkoxy group, an alkenyl group, or an aryl group, and/or
one or more of R⁵, R⁶, R⁷, and R⁸ are an alkyl group, an alkoxy group, an alkenyl group, or an aryl group.

Examples and preferred examples of the alkyl group, alkoxy group, an alkenyl group, and an aryl group in Formula (II) are the same as those of the alkyl group, alkoxy group, alkenyl group, and aryl group exemplified in the description of Formula (I).

In consideration of ease of synthesis of the phenylene sulfide-phenylene oxide copolymer (P1), the alkyl group, alkoxy group, alkenyl group, or aryl group in Formula (II) preferably includes an alkyl group and/or an alkenyl group, more preferably is selected from alkyl groups having from 1 to 10 carbons and alkenyl groups having from 2 to 10 carbons, still more preferably includes linear alkyl groups having from 1 to 4 carbons and/or linear alkenyl groups having from 2 to 5 carbons, even still more preferably includes an ethyl group, a methyl group, a vinyl group, or an allyl group, and even still more preferably includes a methyl group.

The substitution position by an alkyl group, an alkoxy group, an alkenyl group, or an aryl group in Formula (II) is not limited as long as one or more (preferably two or more, for example, two, three, or four) of R¹, R², R³, and R⁴, and/or one or more (preferably two or more, for example, two, three, or four) of R⁵, R⁶, R⁷, and R⁸ are selected for the substitution positions.

In one embodiment, from the viewpoint of easily obtaining the additional characteristic of the dielectric loss tangent being less likely to be higher even at a higher frequency, it is preferable that one or more (preferably two or more, for example, two, three, or four) of R^{1a}, R^{2a}, R^{3a}, and R^{4a} be an alkyl group, an alkoxy group, an alkenyl group, or an aryl group, and one or more (preferably two or more, for example, two, three, or four) of R^{5a}, R^{6a}, R^{7a}, and R^{8a} be an alkyl group, an alkoxy group, an alkenyl group, or an aryl group.

In one embodiment, two of R¹, R², R³, and R⁴ may be alkyl groups, alkoxy groups, alkenyl groups, or aryl groups, and two of R⁵, R⁶, R⁷, and R⁸ may be alkyl groups, alkoxy groups, alkenyl groups, or aryl groups.

In one embodiment, the substitution position of an alkyl group, an alkoxy group, an alkenyl group, or an aryl group may be R¹, R², R³ and/or R⁴ of R¹, R², R³, and R⁴, and may be R⁵, R⁶, R⁷ and/or R⁸ of R⁵, R⁶, R⁷, and R⁸.

In a case where two or more of R¹, R², R³, and R⁴ are alkyl groups, alkoxy groups, alkenyl groups, or aryl groups, the combination of the substitution positions is not limited. For example, in the case where two of R¹, R², R³, and R⁴ are alkyl groups, alkoxy groups, alkenyl groups, or aryl groups, the substitution positions may be any combination of R¹ and R², R¹ and R³, R¹ and R⁴, R² and R³, R² and R⁴, and R³ and R⁴. In a case where three of R¹, R², R³, and R⁴ are alkyl groups, alkoxy groups, alkenyl groups, or aryl groups, the substitution positions may be any combination of R¹, R², and R³, R¹, R², and R⁴ , R¹, R³, and R⁴, and R², R³, and R⁴.

In a case where two or more of R⁵, R⁶, R⁷, and R⁸ are alkyl groups, alkoxy groups, alkenyl groups, or aryl groups, the combination of the substitution positions is not limited. For example, in a case where two of R⁵, R⁶, R⁷, and R⁸ are alkyl groups, alkoxy groups, alkenyl groups, or aryl groups, the substitution positions may be any combination of R⁵ and R⁶, R⁵ and R⁷, R⁵ and R⁸, R⁶ and R⁷, R⁶ and R⁸, and R⁷ and R⁸. In a case where three of R⁵, R⁶, R⁷, and R⁸ are alkyl groups, alkoxy groups, alkenyl groups, or aryl groups, the substitution positions may be any combination of R⁵, R⁶, and R⁷, R⁵, R⁶, and R⁸, R⁵, R⁷, and R⁸, and R⁶, R⁷, and R⁸.

In one embodiment, R¹, R², R³, and R⁴ are H, and R⁶ and R⁷ may be each independently an alkyl group, an alkoxy group, an alkenyl group, or an aryl group, may be an alkyl group having from 1 to 10 carbons or an alkenyl group having from 2 to 10 carbons, may be a linear alkyl group having from 1 to 4 carbons or a linear alkenyl group having from 2 to 5 carbons, may be an ethyl group, a methyl group, a vinyl group, or an allyl group, and may be a methyl group.

In one embodiment, from the viewpoint of easily obtaining the additional characteristic of the dielectric loss tangent being less likely to be higher even at a higher frequency, R² and R³, and R⁶ and R⁷, or R¹ and R⁴, and R⁶ and R⁷ are each independently preferably an alkyl group, an alkoxy group, an alkenyl group, or an aryl group, more preferably an alkyl group having from 1 to 10 carbons or an alkenyl group having from 2 to 10 carbons, still more preferably a linear alkyl group having from 1 to 4 carbons or a linear alkenyl group having from 2 to 5 carbons, even still more preferably an ethyl group, a methyl group, a vinyl group, or an allyl group, and particularly preferably a methyl group.

In one embodiment, the constituent unit represented by Formula (I) preferably includes a constituent unit represented by Formula (III): 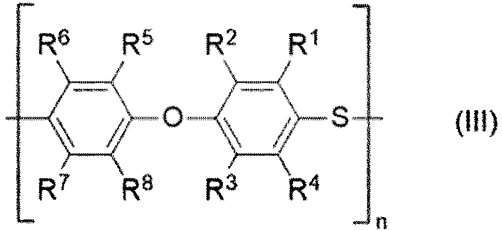 where R¹, R², R³, R⁴, R⁵, R⁶, R⁷, and R⁸ are the same as those described in Formula (II), and n is a number of 4 or more. n is preferably from 4 to 100, and more preferably from 4.5 to 50. The phenylene sulfide-phenylene oxide copolymer (P1) including the constituent unit represented by Formula (III) is a phenylene sulfide-phenylene oxide alternating copolymer having a phenylene sulfide structure and a phenylene oxide structure alternately in the molecule.

The description of R¹, R², R³, R⁴, R⁵, R⁶, R⁷, and R⁸ is the same as the description in Formula (II).

In one embodiment, examples of the constituent unit represented by Formula (I) include the following constituent units, but are not limited thereto:

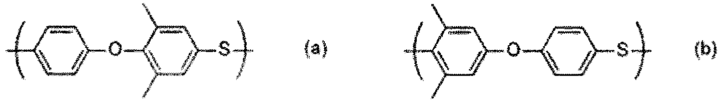

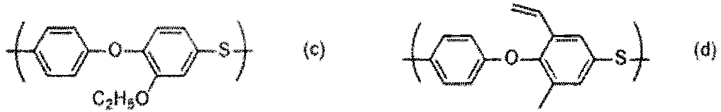

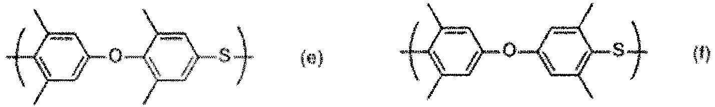

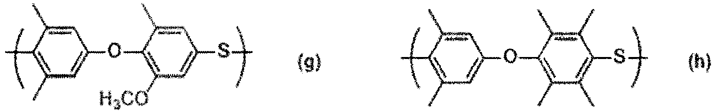

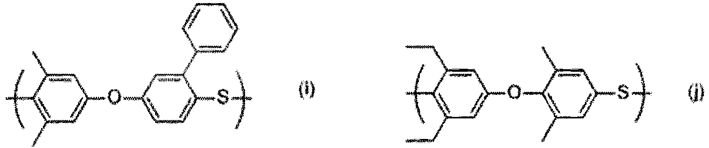

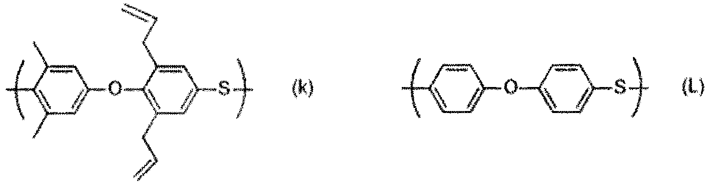

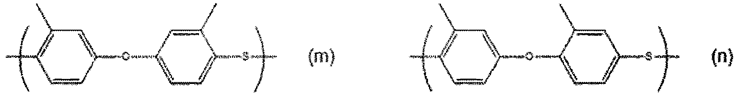

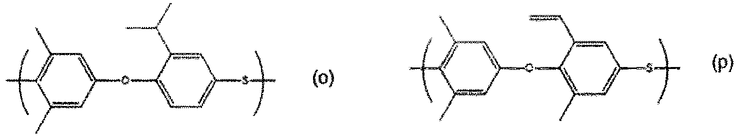

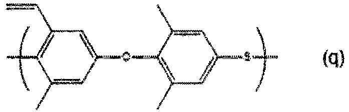

In one embodiment, the constituent unit represented by Formula (I) may include one or more constituent units selected from Formulas (a) to (q), may include one or more constituent units selected from Formulas (a) to (d), may include one or more constituent units selected from Formulas (e) to (k), and may include one or more constituent units selected from Formulas (m) to (q). In one embodiment, the constituent unit represented by Formula (I) may include one or more constituent units represented by Formula (a) and/or Formula (b), and may include one or more constituent units represented by Formula (e) and/or Formula (f).

In one embodiment, the phenylene sulfide-phenylene oxide copolymer (P1) for a wiring board may be composed of only the constituent unit represented by Formula (I), or may include a constituent unit other than the constituent unit represented by Formula (I).

The constituent unit represented by Formula (I) may be one type of constituent unit, or may be two or more types of constituent units as long as they are represented by Formula (I). The constituent unit represented by Formula (I) includes two or more types of constituent units having different combinations of substituents as exemplified in the description of Formula (I).

The constituent unit other than the constituent unit represented by Formula (I) may include one or more of the followings except the phenylene sulfide-phenylene oxide copolymer (P1): a constituent unit having a phenylene sulfide structure and a phenylene oxide structure and having one or more substituents; a constituent unit having a phenylene sulfide structure and a phenylene oxide structure and having no substituents; a constituent unit having only a substituted or unsubstituted phenylene sulfide structure; a constituent unit having only a substituted or unsubstituted phenylene oxide structure; and/or a constituent unit having neither phenylene sulfide structure nor phenylene oxide structure.

In one embodiment, the content of the constituent unit represented by Formula (I) is preferably 60 mol% or more, more preferably 80 mol% or more, and still more preferably 90 mol% or more, with respect to all constituent units. When the content of the constituent unit represented by Formula (I) is 60 mol% or more with respect to all constituent units, the dielectric loss tangent is more likely to be lowered.

### (Dielectric Loss Tangent)

The phenylene sulfide-phenylene oxide copolymer (P1) according to the present embodiment has a low dielectric loss tangent, and thus can be preferably used for production of a wiring board. When the dielectric loss tangent is lower, the transmission loss is more easily suppressed.

In one embodiment, a dielectric loss tangent at 10 GHz of a molded article of the phenylene sulfide-phenylene oxide copolymer (P1) is preferably less than 0.002, more preferably less than 0.0018, and still more preferably less than 0.0017.

In one embodiment, a dielectric loss tangent at 40 GHz of the molded article of the phenylene sulfide-phenylene oxide copolymer (P1) is preferably less than 0.002, more preferably less than 0.0018, and still more preferably less than 0.0017.

In one embodiment, a dielectric loss tangent at 60 GHz of the molded article of the phenylene sulfide-phenylene oxide copolymer (P1) is preferably less than 0.002, and more preferably less than 0.0018.

In one embodiment, a dielectric loss tangent at 80 GHz of the molded article of the phenylene sulfide-phenylene oxide copolymer (P1) is preferably less than 0.002, and more preferably less than 0.0019.

When the dielectric loss tangent of the phenylene sulfide-phenylene oxide copolymer (P1) is lower, the transmission loss is more easily suppressed in a case where the phenylene sulfide-phenylene oxide copolymer (P1) or a resin composition containing the phenylene sulfide-phenylene oxide copolymer (P1) is used as the material for a wiring board.

A general resin for a wiring board tends to have a higher dielectric loss tangent at a higher frequency, but the phenylene sulfide-phenylene oxide copolymer (P1) according to the present embodiment is unlikely to have a higher dielectric loss tangent even at a higher frequency, as an additional characteristic.

In one embodiment, in the molded article of the phenylene sulfide-phenylene oxide copolymer (P1), a ratio tan δ₈₀/tan δ₁₀ of the dielectric loss tangent tan δ₈₀ at 80 GHz to the dielectric loss tangent tan δ₁₀ at 10 GHz is preferably 1.5 or less, more preferably 1.3 or less, still more preferably 1.2 or less, and particularly preferably 1.1 or less.

In the molded article in which the ratio tan δ₈₀/tan δ₁₀ of the dielectric loss tangent tan δ₈₀ at 80 GHz to the dielectric loss tangent tan δ₁₀ at 10 GHz is 1.5 or less, the dielectric loss tangent is less likely to be higher even at a higher frequency, and frequency dependence is low. Accordingly, it is not necessary to change the design of the wiring board material for each frequency, and versatility is high. As a result, the wiring board can be produced more efficiently and economically.

Examples of a method for adjusting the dielectric loss tangent include a method of adjusting a content of the constituent unit represented by Formula (I) in the phenylene sulfide-phenylene oxide copolymer (P1), and a method of adjusting presence or absence of a substituent in the constituent unit represented by Formula (I), the number of substituents, and the like. By any of these methods or a combination thereof, the dielectric loss tangent can be adjusted to be lower, and the dielectric loss tangents at 10 GHz, 40 GHz, 60 GHz, and 80 GHz each can be adjusted to be less than 0.002. In addition, the ratio tan δ₈₀/tan δ₁₀ of the dielectric loss tangent tan δ₈₀ at 80 GHz to the dielectric loss tangent tan δ₁₀ at 10 GHz can be set to 1.5 or less. For example, the more the content of the constituent unit represented by Formula (I) is in the phenylene sulfide-phenylene oxide copolymer (P1), the lower the dielectric loss tangent tends to be. When at least one (preferably both) of Ph¹ and Ph² in Formula (I) has one or more substituents, the dielectric loss tangent is more likely to be lowered, and when both of Ph¹ and Ph² have one or more substituents, tan δ₈₀/tan δ₁₀ is easily adjusted to be 1.5 or less.

### (Dielectric Constant)

In one embodiment, in the phenylene sulfide-phenylene oxide copolymer (P1), a dielectric constant at 10 GHz is preferably less than 3.00, more preferably less than 2.90, and still more preferably less than 2.80.

In one embodiment, in the phenylene sulfide-phenylene oxide copolymer (P1), a dielectric constant at 40 GHz is preferably less than 3.00, more preferably less than 2.90, still more preferably less than 2.80, and particularly preferably less than 2.60.

In one embodiment, in the phenylene sulfide-phenylene oxide copolymer (P1), a dielectric constant at 60 GHz is preferably less than 3.00, more preferably less than 2.90, still more preferably less than 2.80, and particularly preferably less than 2.65.

**In** one embodiment, in the phenylene sulfide-phenylene oxide copolymer (P1), a dielectric constant at 80 GHz is preferably less than 3.00, more preferably less than 2.90, still more preferably less than 2.80, and particularly preferably less than 2.65.

When the dielectric constant of the phenylene sulfide-phenylene oxide copolymer (P1) is lower, the transmission loss is more easily suppressed in a case where the phenylene sulfide-phenylene oxide copolymer (P1) or the resin composition containing the phenylene sulfide-phenylene oxide copolymer (P1) is used as the material for a wiring board.

Examples of the method for adjusting the dielectric constant include a method of adjusting the content of the constituent unit represented by Formula (I) in the phenylene sulfide-phenylene oxide copolymer (P1), and a method of adjusting the presence or absence of a substituent in the constituent unit represented by Formula (I), the number of substituents, and the like. By any of these methods or a combination thereof, the dielectric constant can be adjusted to be lower, and the dielectric constants at 10 GHz, 40 GHz, 60 GHz, and 80 GHz can be adjusted to be less than 3.00. For example, the more the content of the constituent unit represented by Formula (I) is in the phenylene sulfide-phenylene oxide copolymer (P1), the lower the dielectric constant is likely to be. When at least one (preferably both) of Ph¹ and Ph² in Formula (I) has one or more substituents, the dielectric constant is more likely to be lowered.

### (Measurement of Dielectric Loss Tangent and Dielectric Constant)

For measurement of the dielectric loss tangent and the dielectric constant, a film of a resin or a resin composition prepared to have a thickness of from 50 to 250 µm can be heated at from 200°C to 250°C for 120 minutes to form a sample piece of the resin or the resin composition for measurement, and the sample piece can be used.

The dielectric loss tangent and the dielectric constant can be measured at 10 GHz, 40 GHz, 60 GHz, or 80 GHz, for example, under conditions of a standard environment (23 ± 2°C) and a relative humidity of from 45 to 55% by means of a vector network analyzer (N5290A) and a split cylinder resonator, both available from Keysight Technologies.

### (Glass Transition Temperature Tg)

In one embodiment, the phenylene sulfide-phenylene oxide copolymer (P1) preferably has a glass transition temperature (Tg) of higher than 120°C, and more preferably higher than 140°C. When the glass transition temperature (Tg) is higher than 120°C, the phenylene sulfide-phenylene oxide copolymer (P1) can have high heat resistance. The upper limit of the glass transition temperature (Tg) may be 250°C or lower, or may be 200°C or lower. The glass transition temperature can be measured by differential scanning calorimetry (DSC) in accordance with JIS standard (JIS K 7121: Method for measuring transition temperature of plastics) under a temperature increase condition at 20°C/min from room temperature.

### (Weight Average Molecular Weight Mw)

In one embodiment, a weight average molecular weight (Mw) of the phenylene sulfide-phenylene oxide copolymer (P1) is not limited as long as the effects of the present disclosure are obtained, but is preferably less than 30000. In a case where the weight average molecular weight of the phenylene sulfide-phenylene oxide copolymer (P1) is less than 30000, the weight average molecular weight may be 28000 or less, 25000 or less, or 24000 or less.

The weight average molecular weight (Mw) is a value in terms of standard polystyrene determined by GPC measurement using a chloroform solvent.

### [Method for Producing Phenylene Sulfide-Phenylene Oxide Copolymer (P1)]

A method for producing the phenylene sulfide-phenylene oxide copolymer (P1) is not limited, and the copolymer can be produced, for example, by subjecting a disulfide monomer having a phenylene oxide skeleton to oxidative polymerization.

As a specific example, there is exemplified a method for producing the phenylene sulfide-phenylene oxide copolymer (P1) in a case where Ph¹ and Ph² in Formula (I) each have methyl groups at the 3- and 5-positions.

First, a disulfide monomer having a phenylene oxide skeleton is prepared. 4-bromo-2,6-dimethylphenol and 5-iodo-m-xylene are reacted in the presence of copper ferrite, cesium carbonate, and 2,2,6,6,-tetramethyl-3,5-heptanedione (THD) in an N-methylpyrrolidone (NMP) solvent under an inert gas (e.g., nitrogen) atmosphere at 120 to 150°C for 18 to 30 hours to produce a mixture of 5-bromo-2-(3,5-dimethylphenoxy)-1,3-dimethylbenzene and 5-iodo-2-(3,5-dimethylphenoxy)-1,3-dimethylbenzene. This mixture is reacted in the presence of copper sulfate pentahydrate, potassium hydroxide, and 1,2-ethanedithiol in a DMSO/H₂O mixed solvent under an inert gas (for example, nitrogen) atmosphere at 80 to 140°C for 15 to 25 hours to produce 4-(3,5-dimethylphenoxy)-3,5-dimethylbenzenethiol. Chloroform and a methanol solution of iodine are added dropwise thereto, the mixture is stirred, and the mixture is reacted at room temperature (24 to 26°C) for 30 minutes to 2 hours, and then a 10 wt.% sodium thiosulfate aqueous solution is added dropwise thereto to produce 1,2-bis(4-(3,5-dimethylphenoxy)-3,5-dimethylphenyl)disulfane (hereinafter, also referred to as "3',5'-3,5-DPS") as a disulfide monomer having a phenylene oxide skeleton.

Next, 3',5'-3,5-DPS is added to the mixture of DDQ, dichloromethane, and TFA, and the mixture is reacted at room temperature (24 to 26°C) for 15 to 25 hours to be subjected to oxidative polymerization, whereby poly(3,5-dimethyl-4-(3',5'-dimethyl-1',4'-phenoxy)-1-phenylene sulfide) (hereinafter, also referred to as "PMPS-PPO"), which is the phenylene sulfide-phenylene oxide copolymer (P1), can be produced.

### [Resin Composition (C1)]

A resin composition (C1) according to the first embodiment contains the phenylene sulfide-phenylene oxide copolymer (P1) for a wiring board described above. The resin composition (C1) contains the phenylene sulfide-phenylene oxide copolymer (P1) described above. Thus, the resin composition (C1) can achieve a low dielectric loss tangent, and can be preferably used as a resin composition for a wiring board. The phenylene sulfide-phenylene oxide copolymer (P1) is as described above.

The resin composition (C1) may be composed of only the phenylene sulfide-phenylene oxide copolymer (P1) for a wiring board, or may contain an additional component. Examples of the additional component include resins other than the phenylene sulfide-phenylene oxide copolymer for a wiring board, a curing catalyst, a flame retardant, a flame retardant synergist, a fiber reinforcing agent, an inorganic or organic filler, a thermosetting additive, and/or a thermoplastic additive.

In one embodiment, the content of the phenylene sulfide-phenylene oxide copolymer (P1) in the resin composition (C1) is preferably 30 mass% or more with respect to the total amount of the resin composition (C1). In a case where the content is 30 mass% or more, it may be 40 mass% or more, 50 mass% or more, 60 mass% or more, 70 mass% or more, 80 mass% or more, 90 mass% or more, or 100 mass%.

When the content of the phenylene sulfide-phenylene oxide copolymer (P1) in the resin composition (C1) is 30 mass% or more, the dielectric loss tangent of the resin composition (C1) is likely to be lowered. In addition, the dielectric constant is likely to be lowered.

In one embodiment, the content of the phenylene sulfide-phenylene oxide copolymer (P1) in resin components contained in the resin composition (C1) is preferably 50 mass% or more with respect to the total amount of the resin components. In a case where the content is 50 mass% or more, it may be 60 mass% or more, 70 mass% or more, 80 mass% or more, 90 mass% or more, 95 mass% or more, 98 mass% or more, or 100 mass%. When the content of the phenylene sulfide-phenylene oxide copolymer (P1) in the resin components is 50 mass% or more, the dielectric loss tangent of the resin composition (C1) is likely to be lowered. In addition, the dielectric constant is likely to be lowered.

The method for producing the resin composition (C1) is not limited, and the production can be carried out by equipment and a method generally used in preparing a resin composition. In general, the resin composition (C1) is often in the form of a polymer solution (resin varnish) prepared by dissolving the phenylene sulfide-phenylene oxide copolymer in an organic solvent. The phenylene sulfide-phenylene oxide copolymer (P1) and additional components soluble in the organic solvent may be added to the organic solvent and mixed, for example, by stirring with a stirrer, for preparing such a resin varnish. In this case, heating may be performed, if necessary. Thereafter, a component (for example, an inorganic filler) insoluble in the organic solvent may be appropriately added, and the mixture may be dispersed until a predetermined dispersion state is achieved using a ball mill, a bead mill, a planetary mixer, a roll mill, or the like, thereby preparing a resin varnish. Examples of the organic solvent are the same as those which will be described below in the section "Varnish".

### [Article (A1)]

An article (A1) according to the first embodiment includes the phenylene sulfide-phenylene oxide copolymer (P1) and/or the resin composition (C1). The article (A1) can be used for various applications, and can be preferably used as an insulating article in a terminal of a mobile communication system, based on the characteristic of the article being likely to have a low dielectric loss tangent. The article (A1) can be used for various applications requiring high-speed communication. For example, the article (A1) may be mounted on network devices/terminals, servers, AI processors, in-vehicle/aviation devices, home game machines, and the like.

The article (A1) has a dielectric loss tangent at 10 GHz of preferably less than 0.002, more preferably less than 0.0018, and more preferably less than 0.0017. In one embodiment, the article (A1) has a dielectric loss tangent at 40 GHz of preferably less than 0.002, more preferably less than 0.0018, and more preferably less than 0.0017.

In one embodiment, the article (A1) has a dielectric loss tangent at 60 GHz of preferably less than 0.002, and more preferably less than 0.0018.

In one embodiment, the article (A1) has a dielectric loss tangent at 80 GHz of preferably less than 0.002, and more preferably less than 0.0019. When the dielectric loss tangent of the article (A1) is lower, the transmission loss is more easily suppressed.

The article (A1) has an additional effect that the dielectric loss tangent is less likely to be higher even at a higher frequency.

In one embodiment, in the article (A1), the ratio tan δ₈₀/tan δ₁₀ of the dielectric loss tangent tan δ₈₀ at 80 GHz to the dielectric loss tangent tan δ₁₀ at 10 GHz of the molded article is preferably 1.5 or less, more preferably 1.3 or less, still more preferably 1.2 or less, and particularly preferably 1.1 or less. The dielectric loss tangent at 10 GHz is preferably less than 0.002, and more preferably less than 0.001.

Examples of the article (A1) include a wiring board and a wiring board material.

### (Wiring Board)

The wiring board includes the phenylene sulfide-phenylene oxide copolymer (P1) and/or the resin composition (C1). The wiring board includes the phenylene sulfide-phenylene oxide copolymer (P1) and/or the resin composition (C1), and thus can be a wiring board having a low dielectric loss tangent.

The wiring board is a board to be attached with an electronic component such as a semiconductor and to be provided with wiring, and is not limited by its structure and/or application. In the present description, the wiring board includes a portion other than an electronic component other than a semiconductor in a printed wiring board, and, as the wiring board, a print circuit board (PCB) of the printed wiring board can be exemplified. The print circuit board may be, for example, a multilayer print circuit board described below in "Interlayer Insulating Material". The print circuit board encompasses all of a rigid board, a flexible board, a rigid flexible board, a metal-based board, and the like. An electronic component can be mounted on any of these print circuit boards, to form a printed wiring board. That is, the printed wiring board includes the wiring board and the electronic component.

The printed wiring board is not limited by its structure and/or application as long as it includes the wiring board and the electronic component. For example, the printed wiring board may be produced by mounting an electronic component on any print circuit board such as a rigid board, a flexible board, a rigid flexible board, or a metal-based board.

Examples of the electronic component include, but are not limited to, a semiconductor chip, a resistor, and a capacitor. As a structure, for example, wiring or an electronic component may be mounted on one surface or both surfaces of a wiring board (print circuit board), or wiring or an electronic component may be mounted between layers of a wiring board having a multilayer structure.

As applications, for example, a rigid printed wiring board in which an electronic component is mounted on a rigid board can be used in a terminal of a mobile communication system, a base station, a server, a router, a millimeter wave radar, a probe card, or the like, and a flexible printed wiring board in which an electronic component is mounted on a flexible board can be used in a connection cable, an antenna, an antenna cable, or the like.

### (Wiring Board Material)

The wiring board material is a material for producing the wiring board, and contains the phenylene sulfide-phenylene oxide copolymer (P1) and/or the resin composition (C1). The wiring board material includes the phenylene sulfide-phenylene oxide copolymer (P1) or the resin composition (C1), and thus it is possible to produce a wiring board having a low dielectric loss tangent.

In one embodiment, the wiring board material may be a varnish, an interlayer insulating material, a prepreg, a metal-clad laminate, or a substrate. In one embodiment, the wiring board material may be a compatibilizer.

The varnish contains the phenylene sulfide-phenylene oxide copolymer (P1) and/or the resin composition (C1), and an organic solvent. Examples of the varnish include a polymer solution (resin varnish) prepared by dissolving the phenylene sulfide-phenylene oxide copolymer (P1) and/or the resin composition (C1) in an organic solvent. In this polymer solution, at least a part of the polymer may be dissolved at a liquid temperature of 25°C, but preferably, the polymer is completely dissolved.

The organic solvent used in the polymer solution is not limited and can be selected by those skilled in the art from organic solvents well known in the art. Examples of the organic solvent include acetone, ethyl acetate, cyclohexane, heptane, tetrahydrofuran, dimethylformamide, dimethylacetamide, dimethyl sulfoxide, ethylene glycol, cellosolve, carbitol, anisole, N-methylpyrrolidone, propylene glycol monomethyl ether, methyl ether acetate, toluene, cyclohexanone, methyl ethyl ketone, and methyl isobutyl ketone. One type selected from these organic solvents may be used, or two or more types selected therefrom may be used in combination.

The lower limit of the content of the phenylene sulfide-phenylene oxide copolymer (P1) in the polymer solution is not limited as long as a handleable and adequately producible polymer solution is produced. For example, the lower limit may be 5 mass% or more, 7 mass% or more, 10 mass% or more, or 15 mass% or more with respect to 100 mass% of the polymer solution. Meanwhile, the upper limit of the content of the phenylene sulfide-phenylene oxide copolymer (P1) in the polymer solution may be 50 mass% or less, 45 mass% or less, 40 mass% or less, or 35 mass% or less with respect to 100 mass% of the polymer solution.

The interlayer insulating material includes the phenylene sulfide-phenylene oxide copolymer (P1) and/or the resin composition (C1). Examples of the interlayer insulating material include interlayer insulating materials used in printed wiring boards and the like. The interlayer insulating material can also be used as a material for a multilayer printed wiring board.

For example, a varnish containing the phenylene sulfide-phenylene oxide copolymer (P1) and/or the resin composition (C1) is an example of the interlayer insulating material, and a laminate structure of a multilayer print circuit board can also be prepared by applying the varnish to another material, evaporating the solvent, and forming an insulating film layer.

The prepreg contains the phenylene sulfide-phenylene oxide copolymer (P1) and/or the resin composition (C1) and a base material. An example of the prepreg includes a prepreg produced by impregnating a base material with a varnish containing the phenylene sulfide-phenylene oxide copolymer (P1) and/or the resin composition (C1) and an organic solvent, followed by drying. The base material used in the prepreg is not limited and can be selected by those skilled in the art from materials well known in the art, and examples of the base material include natural fiber base materials, organic synthetic fiber base materials, and inorganic fiber base materials.

The metal-clad laminate includes the phenylene sulfide-phenylene oxide copolymer (P1) and/or the resin composition (C1), and a metal foil. An example of the metal-clad laminate includes a metal-clad laminate containing the prepreg. Such a metal-clad laminate can be produced, for example, by stacking a plurality of prepregs, stacking a metal foil on one surface or both surfaces of the stacked product, followed by press-molding under heat and pressure. Examples of the metal foil include a copper foil, an aluminum foil, a tin foil, a gold foil, a silver foil, a platinum foil, and a nickel foil. The metal foil can be selected by those skilled in the art in accordance with the properties and applications required of the metal-clad laminate.

The substrate contains the phenylene sulfide-phenylene oxide copolymer (P1) and/or the resin composition (C1). The substrate is a pedestal used together with a semiconductor chip such as a CPU or a memory for protecting the semiconductor chip and mounting it on a print circuit board (PCB). For example, the substrate may be a board portion in FC-BGA (Flip Chip-Ball Grid Array), FC-CSP (Flip Chip Chip Scale Package), or the like.

The compatibilizer contains the phenylene sulfide-phenylene oxide copolymer (P1) and/or the resin composition (C1). The phenylene sulfide-phenylene oxide copolymer (P1) has a phenylene sulfide structure and a phenylene oxide structure (phenylene ether structure), and thus can be preferably used as a compatibilizer for use when mixing a polyarylene sulfide resin and a polyarylene ether resin, for example.

In one embodiment, the compatibilizer may be for a resin composition containing a polyarylene sulfide resin and a polyarylene ether resin. The polyarylene sulfide resin is preferably a substituted polyarylene sulfide resin having one or more substituents (for example, an alkyl group having from 1 to 10 carbons, an alkoxy group having from 1 to 10 carbons, an alkenyl group having from 1 to 10 carbons, and an aryl group) from the viewpoint of being easily dissolved in a solvent.

### <Second Embodiment>

### [Phenylene Sulfide-Phenylene Oxide Copolymer (P2)]

A phenylene sulfide-phenylene oxide copolymer (P2) according to a second embodiment includes a constituent unit represented by Formula (Ia):

-Ph^{1a}-O-Ph^{2a}-S- (Ia)

where
Ph^{1a} and Ph^{2a} each independently represent a phenylene group optionally having a substituent, and
Ph^{1a} and Ph^{2a} each have one or more substituents.

When the constituent unit represented by the formula (Ia) is included, the phenylene sulfide-phenylene oxide copolymer (P2) can more easily achieve a low dielectric loss tangent. In addition, as an additional effect, the dielectric loss tangent is less likely to be higher even at a higher frequency band. In this case, it is not necessary to change the design of the wiring board material for each frequency, and the versatility is higher. Although the mechanism is not clear at this stage, it is possible that, as a non-limiting mechanism, the presence of the phenylene sulfide structure and the phenylene oxide structure makes a plane angle of the phenylene group not constant, and thus dense packing is suppressed, thereby lowering the dielectric loss tangent. Furthermore, it is possible that when each of the two phenylene groups has one or more substituents, the twist angle of the phenylene group becomes less likely to move, and thus the molecular chain becomes less likely to move, which makes the dielectric loss tangent more likely to be lowered. The phenylene sulfide-phenylene oxide copolymer (P2) has a low dielectric loss tangent, and thus can be used in various applications requiring high-speed communication.

Ph^{1a} and Ph^{2a} may have the same type of substituent or different types of substituents from each other. The numbers and the substitution positions of the substituents in Ph^{1a} and Ph^{2a} may be the same or different from each other.

Ph^{1a} and Ph^{2a} each have one or more substituents, can have two or more substituents, and can have two, three, or four substituents. In a case where Ph^{1a} has two or more substituents, the types of the substituents may be the same or different from each other. In a case where Ph^{2a} has two or more substituents, the types of the substituents may be the same or different from each other.

The substitution position of the substituent of Ph^{1a} may be any of the 2-position, the 3-position, the 5-position, and the 6-position. In a case where the Ph^{1a} has two substituents, the positions of the substituents therein may be the 2- and 3-positions (or the 5- and 6-positions), the 2- and 5-positions (or the 3- and 6-positions), the 2- and 6-positions, or the 3- and 5-positions. In a case where the Ph^{1a} has three substituents, the positions of the substituents therein may be either the 2-, 3-, and 5-positions (or the 3-, 5-, and 6-positions) or the 2-, 3-, and 6-positions (or the 2-, 5-, and 6-positions).

The substitution position of the substituent of Ph^{2a} may be any of the 2-position, the 3-position, the 5-position, and the 6-position. In a case where the Ph^{2a} has two substituents, the positions of the substituents therein may be the 2- and 3-positions (or the 5- and 6-positions), the 2- and 5-positions (or the 3- and 6-positions), the 2- and 6-positions, or the 3- and 5-positions. In a case where the Ph^{2a} has three substituents, the positions of the substituents therein may be either the 2-, 3-, and 5-positions (or the 3-, 5-, 6-positions) or the 2-, 3-, 6-positions (or the 2-, 5-, 6-positions).

Examples of the types and preferred types of substituents that Ph^{1a} and Ph^{2a} have are the same as those of the substituents that Ph¹ and Ph² may have in Formula (I) constituting the phenylene sulfide-phenylene oxide copolymer (P1) according to the first embodiment.

In one embodiment, from the viewpoint of easily having the additional characteristic of the dielectric loss tangent being less likely to be higher even at a higher frequency, both Ph^{1a} and Ph^{2a} preferably have one or more selected from the group consisting of an alkyl group, an alkoxy group, an alkenyl group, and an aryl group.

In one embodiment, in consideration of the ease of synthesis of the phenylene sulfide-phenylene oxide copolymer (P2), one or more substituents that Ph^{1a} and Ph^{2a} have in Formula (Ia) are preferably selected from an alkyl group and an alkenyl group, are preferably selected from an alkyl group having from 1 to 10 carbons and an alkenyl group having from 2 to 10 carbons, are more preferably selected from a linear alkyl group having from 1 to 4 carbons and a linear alkenyl group having from 2 to 5 carbons, still more preferably include an ethyl group, a methyl group, a vinyl group and/or an allyl group, and even still more preferably include a methyl group.

In a case where both Ph^{1a} and Ph^{2a} have substituents as described above, the substitution positions may be the same or different from each other. In a case where two or more substituents are included in each of Ph^{1a} and Ph^{2a}, the combination of the substitution positions is not limited.

In one embodiment, in a case where both Ph^{1a} and Ph^{2a} have two substituents, the substitution positions may be at the 3- and 5-positions. In one embodiment, in the case where both Ph^{1a} and Ph^{2a} have two substituents, both may have two substituents selected from an alkyl group, an alkoxy group, an alkenyl group, and an aryl group at the 3- and 5-positions.

In one embodiment, in the case where both Ph^{1a} and Ph^{2a} have two substituents, the substitution positions in one of them (for example, Ph^{1a}) may be the 3- and 5-positions, and the substitution positions in the other (for example, Ph^{2a}) may be the 2- and 6-positions. In one embodiment, in the case where both Ph^{1a} and Ph^{2a} have two substituents, one of them (for example, Ph^{1a)} may have, at the 3- and 5-positions, two substituents selected from the group consisting of an alkyl group, an alkoxy group, an alkenyl group, and an aryl group, and the other (for example, Ph^{2a)} may have, at the 2- and 6-positions, two substituents selected from the group consisting of an alkyl group, an alkoxy group, an alkenyl group, and an aryl group.

In one embodiment, the constituent unit represented by Formula (Ia) preferably includes a constituent unit represented by Formula (IIa): 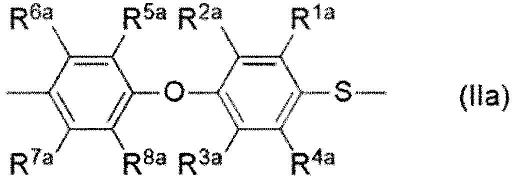 where
R^{1a}, R^{2a}, R^{3a}, R^{4a}, R^{5a} , R^{6a}, R^{7a}, and R^{8a} are each independently H, an alkyl group, an alkoxy group, an alkenyl group, or an aryl group,
one or more of R^{1a}, R^{2a}, R^{3a}, and R^{4a} are an alkyl group, an alkoxy group, an alkenyl group, or an aryl group, and
one or more of R^{5a}, R^{6a}, R^{7a}, and R^{8a} are an alkyl group, an alkoxy group, an alkenyl group, or an aryl group. By having the constituent unit of Formula (IIa), the phenylene sulfide-phenylene oxide copolymer (P2) is likely to have the additional characteristic of the dielectric loss tangent being less likely to be higher even at a higher frequency.

Examples and preferred examples of the alkyl group, alkoxy group, alkenyl group, and aryl group in Formula (IIa) are the same as those of the alkyl group, alkoxy group, alkenyl group, and aryl group exemplified in the description of Formula (I) constituting the phenylene sulfide-phenylene oxide copolymer (P1) in the first embodiment.

In consideration of the ease of synthesis of the phenylene sulfide-phenylene oxide copolymer (P2), the alkyl group, alkoxy group, alkenyl group, or aryl group in Formula (IIa) preferably includes an alkyl and/or alkenyl group, is more preferably selected from an alkyl group having from 1 to 10 carbons and an alkenyl group having from 2 to 10 carbons, is even more preferably include a linear alkyl group having from 1 to 4 carbons and/or a linear alkenyl group having from 2 to 5 carbons, still more preferably includes an ethyl group, a methyl group, a vinyl group, and/or an allyl group, and even still more preferably includes a methyl group.

The substitution position with the alkyl group, the alkoxy group, the alkenyl group, or the aryl group in Formula (IIa) is not limited as long as one or more (preferably two or more, for example, two, three, or four) of R^{1a}, R^{2a}, R^{3a}, and R^{4a}, and one or more (preferably two or more, for example, two, three, or four) of R^{5a}, R^{6a}, R^{7a}, and R^{8a} are selected for the substitution positions.

In one embodiment, two of R^{1a}, R^{2a}, R^{3a}, and R^{4a} may be an alkyl group, an alkoxy group, an alkenyl group, or an aryl group, and two of R^{5a}, R^{6a}, R^{7a}, and R^{8a} may be an alkyl group, an alkoxy group, an alkenyl group, or an aryl group.

In one embodiment, the substitution position of the alkyl group, alkoxy group, alkenyl group or, aryl group may be R^{1a}, R^{2a}, R^{3a}and/or R^{4a} of R^{1a}, R^{2a}, R^{3a}, and R^{4a}, and may be R^{5a}, R^{6a}, R^{7a}, and/or R^{8a} of R^{5a}, R^{6a}, R^{7a}, and R^{8a}.

In a case where two or more of R^{1a}, R^{2a}, R^{3a}, and R^{4a} are an alkyl group, an alkoxy group, an alkenyl group, or an aryl group, the combination of the substitution positions is not limited. For example, in a case where two of R^{1a}, R^{2a}, R^{3a}, and R^{4a} are an alkyl group, an alkoxy group, an alkenyl group, or an aryl group, the substitution positions may be any combination of R^{1a} and R^{2a}, R^{1a} and R^{3a}, R^{1a} and R^{4a}, R^{2a} and R^{3a}, R^{2a} and R^{4a}, and R^{3a} and R^{4a}. In a case where three of R^{1a}, R^{2a}, R^{3a}, and R^{4a} are an alkyl group, an alkoxy group, an alkenyl group, or an aryl group, the substitution positions may be any combination of R^{1a}, R^{2a}, and R^{3a}, R^{1a}, R^{2a}, and R^{4a}, R^{1a}, R^{3a}, and R^{4a}, and R^{2a}, R^{3a}, and R^{4a}.

In a case where two or more of R^{5a}, R^{6a}, R^{7a}, and R^{8a} are an alkyl group, an alkoxy group, an alkenyl group, or an aryl group, the combination of the substitution positions is not limited. For example, in a case where two of R^{5a}, R^{6a}, R^{7a}, and R^{8a} are an alkyl group, an alkoxy group, an alkenyl group, or an aryl group, the substitution positions may be any combination of R^{5a} and R^{6a}, R^{5a} and R^{7a}, R^{5a} and R^{8a}, R^{6a} and R^{7a}, R^{6a} and R^{8a}, and R^{7a} and R^{8a}. In a case where three of R^{5a}, R^{6a}, R^{7a}, and R^{8a} are an alkyl group, an alkoxy group, an alkenyl group, or an aryl group, the substitution positions may be any combination of R^{5a} , R^{6a}, and R^{7a}, R^{5a} , R^{6a}, and R^{8a}, R^{5a} , R^{7a}, and R^{8a}, and R^{6a}, R^{7a}, and R^{8a}.

In one embodiment, R^{2a} and R^{3a}, and R^{6a} and R^{7a}, or R^{1a} and R^{4a}, and R^{6a} and R^{7a} are each independently preferably an alkyl group, an alkoxy group, an alkenyl group, or an aryl group, more preferably an alkyl group having from 1 to 10 carbons or an alkenyl group having from 2 to 10 carbons, still more preferably a linear alkyl group having from 1 to 4 carbons or a linear alkenyl group having from 2 to 5 carbons, even still more preferably an ethyl group, a methyl group, a vinyl group, or an allyl group, and particularly preferably a methyl group.

In one embodiment, the constituent unit represented by Formula (Ia) preferably includes a constituent unit represented by Formula (IIIa): 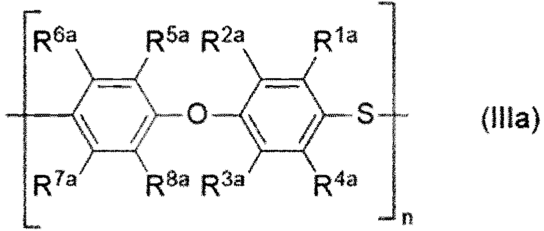 where
R^{1a}, R^{2a}, R^{3a}, R^{4a}, R^{5a}, R^{6a}, R^{7a}, and R^{8a} are the same as those described in Formula (IIa), and
n is a number of 4 or more. n is preferably from 4 to 100, and more preferably from 4.5 to 50. The phenylene sulfide-phenylene oxide copolymer (P2) including the constituent unit represented by Formula (IIIa) is a phenylene sulfide-phenylene oxide alternating copolymer having a phenylene sulfide structure and a phenylene oxide structure alternately in the molecule.

The description of R^{1a}, R^{2a}, R^{3a}, R^{4a}, R^{5a}, R^{6a}, R^{7a}, and R^{8a} is the same as the description of Formula (IIa).

In one embodiment, examples of the constituent unit represented by Formula (Ia) include the following constituent units, but are not limited thereto:

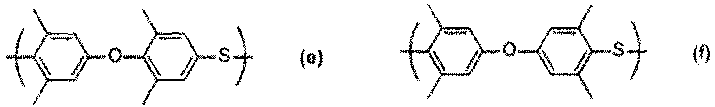

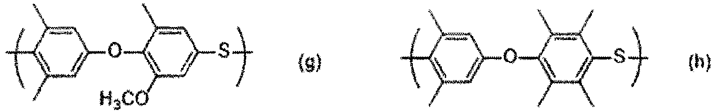

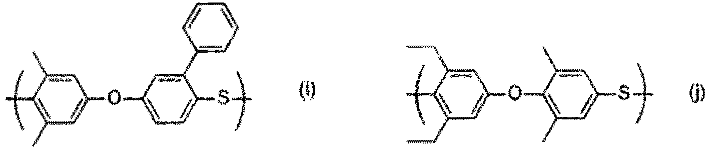

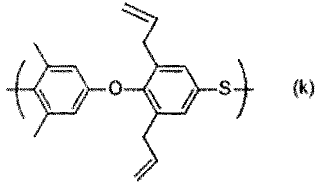

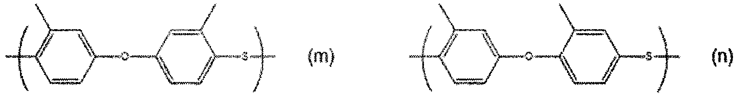

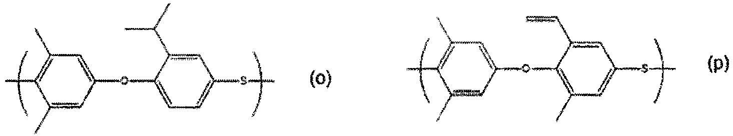

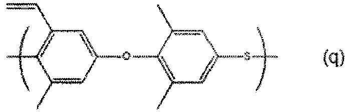

In one embodiment, the constituent unit represented by Formula (Ia) may include one or more constituent units selected from Formulas (e) to (k), and Formulas (m) to (q). In one embodiment, the constituent unit represented by Formula (Ia) may include one or more constituent units represented by Formula (e) and/or Formula (f).

In one embodiment, the phenylene sulfide-phenylene oxide copolymer (P2) may be composed of only the constituent unit represented by Formula (Ia), or may include a constituent unit other than the constituent unit represented by Formula (Ia).

The constituent unit represented by Formula (Ia) may be one constituent unit, or may be two or more constituent units as long as they are represented by Formula (Ia). The constituent unit represented by Formula (Ia) encompasses two or more constituent units having different combinations of substituents as exemplified in the description of Formula (Ia).

The constituent unit other than the constituent unit represented by Formula (Ia) may include one or more of the followings except the phenylene sulfide-phenylene oxide copolymer (P2): a constituent unit having a phenylene sulfide structure and a phenylene oxide structure and having one or more substituents; a constituent unit having a phenylene sulfide structure and a phenylene oxide structure and having no substituents; a constituent unit having only a substituted or unsubstituted phenylene sulfide structure; a constituent unit having only a substituted or unsubstituted phenylene oxide structure; and/or a constituent unit having neither phenylene sulfide structure nor phenylene oxide structure.

In one embodiment, the content of the constituent unit represented by Formula (Ia) is preferably 60 mol% or more, more preferably 80 mol% or more, and still more preferably 90 mol% or more, with respect to all constituent units. When the content of the constituent unit represented by Formula (Ia) is 60 mol% or more with respect to all constituent units, the dielectric loss tangent is more likely to be lowered.

### (Dielectric Loss Tangent)

The phenylene sulfide-phenylene oxide copolymer (P2) according to the present embodiment has a low dielectric loss tangent, and thus can be preferably used for production of a wiring board. When the dielectric loss tangent is lower, the transmission loss is more easily suppressed.

In one embodiment, a dielectric loss tangent at 10 GHz of a molded article of the phenylene sulfide-phenylene oxide copolymer (P2) is preferably less than 0.002, more preferably less than 0.0018, and still more preferably less than 0.0017.

In one embodiment, a dielectric loss tangent at 40 GHz of the molded article of the phenylene sulfide-phenylene oxide copolymer (P2) is preferably less than 0.002, more preferably less than 0.0018, and still more preferably less than 0.0017.

In one embodiment, a dielectric loss tangent at 60 GHz of the molded article of the phenylene sulfide-phenylene oxide copolymer (P2) is preferably less than 0.002, and more preferably less than 0.0018.

In one embodiment, a dielectric loss tangent at 80 GHz of the molded article of the phenylene sulfide-phenylene oxide copolymer (P2) is preferably less than 0.002, and more preferably less than 0.0019.

When the dielectric loss tangent of the phenylene sulfide-phenylene oxide copolymer (P2) is lower, the transmission loss is more easily suppressed in a case where the phenylene sulfide-phenylene oxide copolymer (P2) or a resin composition containing the phenylene sulfide-phenylene oxide copolymer (P2) is used as the material for a wiring board.

A general resin for a wiring board tends to have a higher dielectric loss tangent at a higher frequency, but the phenylene sulfide-phenylene oxide copolymer (P2) according to the present embodiment is unlikely to have a higher dielectric loss tangent even at a higher frequency, as an additional characteristic.

In one embodiment, in the molded article of the phenylene sulfide-phenylene oxide copolymer (P2), the ratio tan δ₈₀/tan δ₁₀ of the dielectric loss tangent tan δ₈₀ at 80 GHz to the dielectric loss tangent tan δ₁₀ at 10 GHz is preferably 1.5 or less, more preferably 1.3 or less, still more preferably 1.2 or less, and particularly preferably 1.1 or less.

In the molded article in which the ratio tan δ₈₀/tan δ₁₀ of the dielectric loss tangent tan δ₈₀ at 80 GHz to the dielectric loss tangent tan δ₁₀ at 10 GHz is 1.5 or less, the dielectric loss tangent is less likely to be higher even at a higher frequency, and frequency dependence is low. Accordingly, it is not necessary to change the design of the wiring board material for each frequency, and versatility is high. As a result, the wiring board can be produced more efficiently and economically.

Examples of the method for adjusting the dielectric loss tangent include the same methods as those described for the phenylene sulfide-phenylene oxide copolymer (P1).

The ranges of the dielectric constant, the glass transition temperature, and the weight average molecular weight (Mw) of the phenylene sulfide-phenylene oxide copolymer (P2), and the adjustment method and the measurement method are the same as those described for the phenylene sulfide-phenylene oxide copolymer (P1) in the first embodiment.

An example of the method for producing the phenylene sulfide-phenylene oxide copolymer (P2) includes the methods described for the phenylene sulfide-phenylene oxide copolymer (P1) in the first embodiment.

### [Resin Composition (C2)]

A resin composition (C2) according to the second embodiment contains the above-described phenylene sulfide-phenylene oxide copolymer (P2). The low dielectric loss tangent can be achieved because the above-described phenylene sulfide-phenylene oxide copolymer (P2) are contained. In addition, as an additional characteristic, the dielectric loss tangent is less likely to be higher even at a higher frequency band. The phenylene sulfide-phenylene oxide copolymer (P2) is as described above.

The resin composition (C2) may be composed of only the phenylene sulfide-phenylene oxide copolymer (P2), or may contain an additional component. Examples of the additional component include the same components as the additional component that may be contained in the resin composition (C1) of the first embodiment.

For the content of the phenylene sulfide-phenylene oxide copolymer (P2) in the resin composition (C2) and the content of the phenylene sulfide-phenylene oxide copolymer (P2) in resin components contained in the resin composition (C2), the same ranges as the content of the phenylene sulfide-phenylene oxide copolymer (P1) in the resin composition (C1) and the content of the phenylene sulfide-phenylene oxide copolymer (P1) in the resin components contained in the resin composition (C1) are exemplified.

An example of the method for producing the resin composition (C2) includes the same method as the method for producing the resin composition (C1) in the first embodiment.

### [Article (A2)]

An article (A2) according to the second embodiment contains the phenylene sulfide-phenylene oxide copolymer (P2) and/or the resin composition (C2). The article (A2) can be used for various applications, and can be preferably used as an insulating article in a terminal of a mobile communication system, based on the characteristic of the article being likely to have a low dielectric loss tangent. The article (A2) can be used for various applications requiring high-speed communication, but, for example, may be mounted on network devices/terminals, servers, AI processors, in-vehicle/aviation devices, home game machines, and the like.

The ranges of the dielectric loss tangent and the dielectric constant of the article (A2), the adjustment method, and the measurement method are the same as those described for the article (A1) in the first embodiment.

Examples of the article (A2) include a wiring board, a wiring board material, and a compatibilizer.

The wiring board includes the phenylene sulfide-phenylene oxide copolymer (P2) and/or the resin composition (C2).

The wiring board material contains the phenylene sulfide-phenylene oxide copolymer (P2) and/or the resin composition (C2). In one embodiment, the wiring board material may be a varnish, an interlayer insulating material, a prepreg, a metal-clad laminate, or a substrate.

The varnish contains the phenylene sulfide-phenylene oxide copolymer (P2) and/or the resin composition (C2), and an organic solvent. The interlayer insulating material includes the phenylene sulfide-phenylene oxide copolymer (P2) and/or the resin composition (C2). The prepreg contains; the phenylene sulfide-phenylene oxide copolymer (P2) and/or the resin composition (C2); and a base material. The metal-clad laminate includes the phenylene sulfide-phenylene oxide copolymer (P2) and/or the resin composition (C2), and a metal foil. The substrate contains the phenylene sulfide-phenylene oxide copolymer (P2) and/or the resin composition (C2).

The other description of the wiring board and various wiring board materials in the first embodiment are also applicable here.

The compatibilizer contains the phenylene sulfide-phenylene oxide copolymer (P2) and/or the resin composition (C2). In one embodiment, the compatibilizer may be for a resin composition containing a polyarylene sulfide resin and a polyarylene ether resin. The polyarylene sulfide resin is preferably a substituted polyarylene sulfide resin having one or more substituents (for example, an alkyl group having from 1 to 10 carbons, an alkoxy group having from 1 to 10 carbons, an alkenyl group having from 1 to 10 carbons, and an aryl group) from the viewpoint of being easily dissolved in a solvent. The other description of the compatibilizer in the first embodiment is also applicable here.

### <Other Embodiments>

### (Use)

In one embodiment, there is provided use of a phenylene sulfide-phenylene oxide copolymer for producing a wiring board, the phenylene sulfide-phenylene oxide copolymer including a constituent unit represented by Formula (I):

-Ph¹-O-Ph²-S- (I)

where Ph¹ and Ph² each independently represent a phenylene group optionally having a substituent. The description of Formula (I) is as described in the first embodiment.

### (Method for Producing Wiring Board)

In one embodiment, there is provided a method for producing a wiring board, the method including molding a phenylene sulfide-phenylene oxide copolymer including a constituent unit represented by Formula (I):

-Ph¹-O-Ph²-S- (I)

where Ph¹ and Ph² each independently represent a phenylene group optionally having a substituent. The molding method is not limited, and examples thereof include hot pressing and thermocompression bonding by known equipment and methods. The description of Formula (I) is as described in the first embodiment.

### Examples

The present disclosure will be described in more detail by way of Examples, but the interpretation of the present disclosure is not limited by the Examples.

Oxidative polymerization of various aromatic disulfides yields the corresponding poly(phenylene sulfide) derivatives. The present inventors have succeeded in synthesizing a novel copolymer P1 of dimethyl-substituted PPS and poly(2,6-dimethyl-1,4-phenyleneoxide) (PPO) by oxidative polymerization of a disulfide monomer M1 having a phenylene oxide skeleton (see Scheme). Scheme:

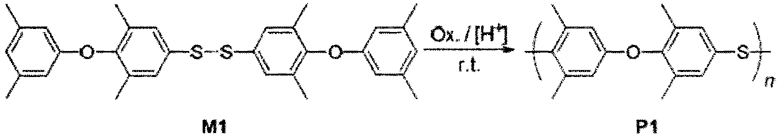

P1 was produced in a high molecular weight form (e.g., Mw of 2.3 × 10⁴), was amorphous and soluble in a common organic solvent, and exhibited high heat resistance (e.g., glass transition temperature Tg > 120°C). It was also found that the dielectric constant was as low as that of PPO. Examples are presented below.

### [Synthesis Example 1] (Synthesis of Monomer)

Monomers for preparing a phenylene sulfide-phenylene oxide copolymer were prepared. The reaction scheme is shown below.

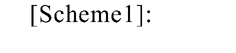

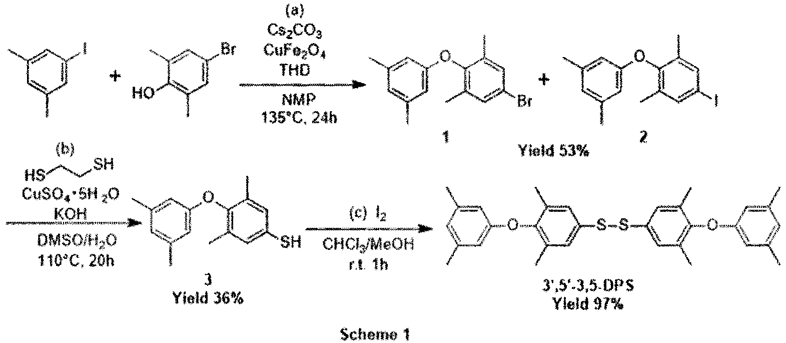

According to (a) of Scheme 1, 4-bromo-2,6-dimethylphenol (81 mmol, 1 eq., 16.2 g), 5-iodo-m-xylene (323 mmol, 4 eq., 75 g), copper ferrite (8.1 mmol, 0.1 eq., 1.94 g), cesium carbonate (162 mmol, 2 eq., 52.8 g), 2,2,6,6-tetramethyl-3,5-heptanedione (THD) (16.2 mmol, 0.2 eq., 3.3 mL), and NMP (162 mL) were added to a 1000-mL recovery flask, and the mixture was stirred at 135°C for 24 hours under a nitrogen gas atmosphere.

A mixture of a compound (1) and a compound (2) (compound (1) : compound (2) = 1.6 : 1 (mol/mol)) was produced as a white solid through silica gel filtration, liquid separation (diethyl ether/saturated saline/5 wt.% potassium hydroxide aqueous solution), dewatering (sodium sulfate), solvent removal, and column chromatography (hexane). Note that the compound (2) is a by-product of Ullman coupling, and it is presumed that it was generated due to halogen exchange between a bromo group and an iodo group between raw materials or products, and it was difficult to separate it by the column chromatography.

Subsequently, according to (b) of Scheme 1, the mixture of the compound (1) and the compound (2) (compound (1) : compound (2) = 26.6 : 16.6 (mmol/mmol), 1 eq., 14.0 g), copper sulfate pentahydrate (2.16 mmol, 0.05 eq., 39 mg), potassium hydroxide (216 mmol, 5 eq., 12 g), 1,2-ethanedithiol (43.2 mmol, 2 eq., 3.6 mL), and DMSO/H2O (100 mL/10 mL) mixed solvent were added to a 1000-mL recovery flask, and the mixture was stirred at 110°C for 20 hours under a nitrogen gas atmosphere. A compound (3) was produced as a white solid through liquid separation (ethyl acetate/5 vol.% hydrochloric acid, pure water, 3.5 wt.% saline), dewatering (sodium sulfate), solvent removal, and column chromatography (hexane/chloroform = 5/1 (v/v)).

Subsequently, according to (c) of Scheme 1, the compound (3) (16 mmol, 1 eq., 4.1 g) and chloroform (50 mL) were added to a 100-mL recovery flask, a methanol solution (25 mL) of iodine (8.0 mmol, 0.5 eq., 2.0 g) was added dropwise thereto, and the mixture was stirred at room temperature for 1 hour. After the reaction, 10 wt.% sodium thiosulfate aqueous solution was added dropwise thereto until the color of the reaction solution was not changed. 1,2-bis(4-(3,5-dimethylphenoxy)-3,5-dimethylphenyl)disulfane (3',5'-3,5-DPS) was produced as a white solid (7.8 mmol, 4.0 g) through liquid separation (chloroform/5 vol.% hydrochloric acid, 5 wt.% sodium hydroxide aqueous solution, 3.5 wt.% saline), dewatering (sodium sulfate), solvent removal, and column chromatography (hexane/chloroform = 3/1 (v/v)).

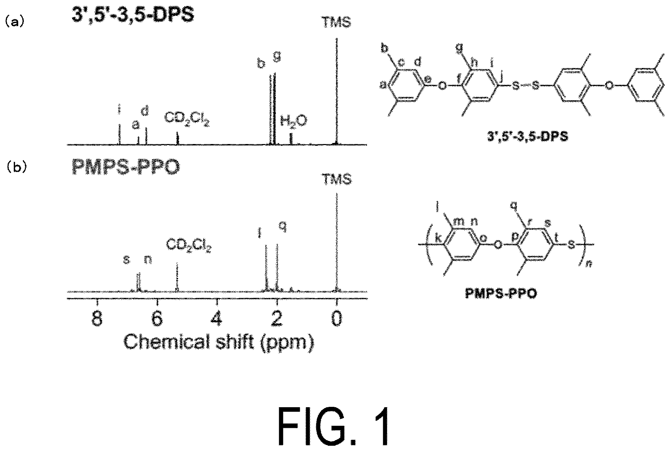

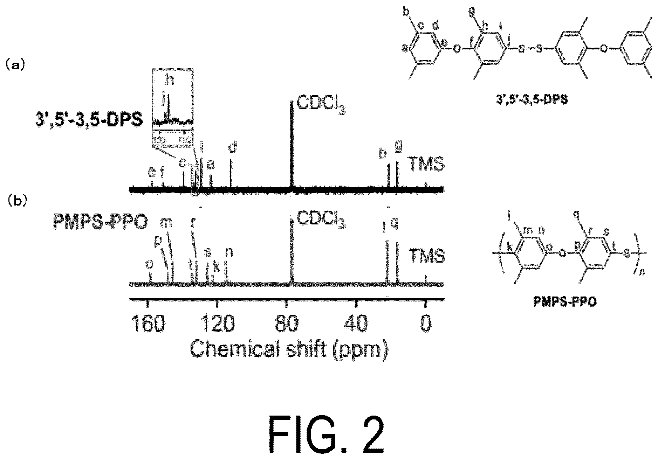

A ¹H-NMR (CD₂Cl₂) chart of the resulting 3',5'-3,5-DPS is shown in FIG. 1 (a), and a ¹³C-NMR (CDCl₃) chart thereof is shown in FIG. 2(a). The identification results are shown below. Note that in the following, a to j correspond to a to j in the structural formulas shown in FIGS. 1 and 2, respectively.
¹H-NMR (δ: ppm, CD₂Cl₂): 7.26 (s, 2H, i), 6.62 (s, 1H, a), 6.36 (s, 2H, d), 2.22 (s, 6H, b), 2.08 (s, 6H, g)
¹³CNMR (δ: ppm, DC13): 157.6 (e), 151.0 (f), 139.5 (c), 132.8 (j), 132.6 (h), 129.2 (i), 123.4 (a), 112.2 (d), 21.4 (b), 16.5 (g)
FAB-MS (m/z): 514.2 (calc.), 514.5 (found)

### [Example 1] PMPS-PPO-1

A phenylene sulfide-phenylene oxide copolymer of Example 1 was prepared using 3',5'-3,5-DPS as a monomer. The reaction scheme is shown below.

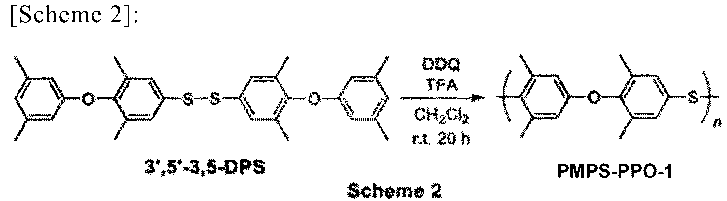

According to Scheme 2, 2,3-dichloro-5,6-dicyano-parabenzoquinone (DDQ, 2.63 mmol, 1 eq., 597 mg), dichloromethane, and trifluoroacetic acid (TFA) were added to a 50-mL recovery flask and mixed uniformly, and then 3',5'-3,5-DPS (2.63 mmol, 1 eq., 1.35 g) was added thereto and stirred at room temperatures for 20 hours. After completion of the reaction, dichloromethane (25 mL) was added, and poly(3,5-dimethyl-4-(3',5'-dimethyl-1',4'-phenoxy)-1-phenylene sulfide) (PMPS-PPO-1) was produced as a white powder through DDH removal by filtration through a glass filter, precipitation purification in 2.5 vol.% hydrochloric acid-acidified methanol (250 mL) and recovery with a glass filter, and precipitation purification in 2.5 vol.% hydrochloric acid-acidified 2-propanol and recovery with a glass filter.

In Scheme 2, CH₂Cl₂ is a solvent, DDQ is an oxidant (1 eq. relative to 3',5'-3,5-DPS), the reaction time is 20 hours, the reaction temperature is room temperature, and n of PMPS-PPO-1 is 28.

The ¹H-NMR (CD₂Cl₂) chart of the resulting PMPS-PPO-1 is shown in FIG. 1(b), and the ¹³C-NMR (CDCl₃) chart is shown in FIG. 2(b).

Peak integral values of the aromatic ring and the methyl group were observed at 1 : 3 in ¹H-NMR, and 10 peaks were observed in ¹³CNMR, which supported a structure in which substitution selectively occurred at the p-position relative to an oxygen atom.

### [Example 2] PMPS-PPO-2

DDQ (2.63 mmol, 1 eq., 597 mg), dichloromethane, and TFA were added to a 50-mL recovery flask and mixed uniformly, and then 3',5'-2,6-DPS (2.63 mmol, 1 eq., 1.35 g) was added thereto and stirred at room temperature for 20 hours. After completion of the reaction, dichloromethane (25 mL) was added, and poly(2,6-dimethyl-4-(3',5'-dimethyl-1',4'-phenoxy)-1-phenylene sulfide) (PMPS-PPO-2) was produced as a yellow powder through DDH removal by filtration through a glass filter, precipitation purification in 2.5 vol.% hydrochloric acid-acidified methanol (250 mL) and recovery through a glass filter, precipitation purification in hexane, and recovery through a glass filter.

PMPS-PPO-2 has the following structural formula: 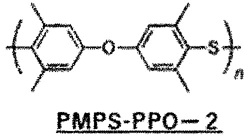 n is 4.7.

### [Comparative Examples 1 and 2]

The following resins were used as resins of Comparative Examples 1 and 2.
PPS: unsubstituted polyphenylene sulfide resin
PPO: 3,5-dimethylpolyphenylene ether resin

### [Comparative Example 3]

3,5-dimethylpolyphenylene ether resin (PPO) and 3,5-dimethyl PPS (DMPPS) were melt-mixed at a mass ratio of 1 : 1 to produce a resin composition (PPO/DMPPS = 1/1) of Comparative Example 3.

### [Reference Example]

As Reference Example, 3,5-dimethyl PPS (DMPPS) was prepared.

56 mL of dichloromethane was introduced into a 100-mL three-necked flask in a nitrogen atmosphere. To the flask were added 3,3'-dimethyldiphenyl disulfide (11.5 g, 42 mmol), 2,3-dichloro-5,6-dicyano-parabenzoquinone (DDQ, 42 mmol), and trifluoromethanesulfonic acid (8.4 mmol). The mixture was stirred at room temperature for 6 hours for oxidative polymerization. The reaction liquid was added dropwise to hydrochloric acid-acidified methanol, and the resultant powder was recovered by filtration. Thereafter, the powder was washed with an aqueous potassium hydroxide solution (0.1 M) and pure water, and vacuum dried to produce a polymer.

### [Measurement]

### (Weight Average Molecular Weight Mw)

For each resin of Examples 1 and 2, Comparative Examples 1 and 2, and Reference Example, the weight average molecular weight (Mw) in terms of polystyrene was measured by gel permeation chromatography (GPC). The results are shown in Table 1.

### (Glass Transition Temperature Tg)

For each resin of Examples 1 and 2, Comparative Examples 1 and 2, and Reference Example, the glass transition temperature (Tg) was measured by differential scanning calorimetry (DSC) in accordance with JIS standard (JIS K 7121: Method for measuring transition temperature of plastics) under a temperature increase condition at 20°C/min from room temperature. The results are shown in Table 1.

### (Measurement of Dielectric Loss Tangent and Dielectric Constant)

For measurement of the dielectric loss tangent and the dielectric constant, for each resin of Examples 1 and 2, Comparative Examples 1 and 2, and Reference Example, a resin film prepared with a thickness of 100 µm was heated at 5°C/min from room temperature, and held at 240°C for 120 minutes with a pressure of 5 kN applied to prepare a resin sample piece for measurement.

The dielectric loss tangent and the dielectric constant were measured at 10 GHz by a cavity resonator perturbation method under conditions of a standard environment (23 ± 2°C) and a relative humidity of from 45 to 55% by means of a vector network analyzer (N5290A) and a split cylinder resonator, both available from Keysight Technologies. The results are shown in Table 1.

**[Table 1]**

| | Example 1 | Example 2 | Comparative Example 1 | Comparative Example 2 | Reference Example |
|---|---|---|---|---|---|
| Resin (copolymer) | PMPS-PPO-1 | PMPS-PPO-2 | PPS | PPO | 3,5-Dimethyl PPS resin |
| Weight average molecular weight Mw | 23000 | 2900 | About 40000 | About 40000 | 7000 |
| Glass transition temperature Tg (°C) | 190 | 143 | 90 | 210 | 153 |
| Dielectric constant (Dk: 10 GHz) | 2.76 | 2.64 | 3.31 | 2.4 | 2.45 |
| Dielectric loss tangent (Df: 10 GHz) | 0.00169 | 0.00130 | 0.00253 | 0.00160 | 0.00087 |

### (Frequency Dependence of Dielectric Loss Tangent)

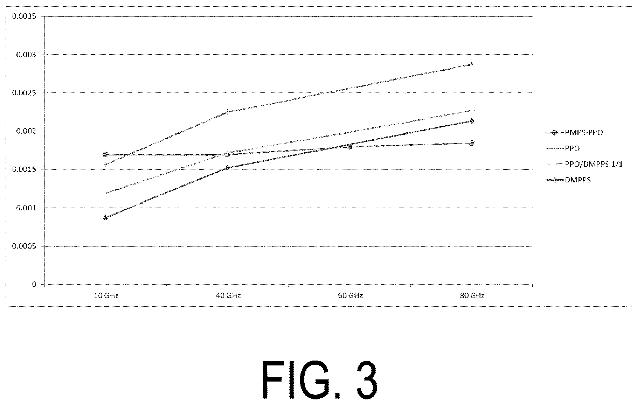

For the resins of Example 1, Comparative Examples 1 to 3, and Reference Example, the dielectric loss tangents at 40 GHz, 60 GHz, and 80 GHz were measured under the same conditions as described above. A ratio tan δ₈₀/tan δ₁₀ of the dielectric loss tangent tan δ₈₀ at 80 GHz to the dielectric loss tangent tan δ₁₀ at 10 GHz shown in Table 1 was calculated. The results are shown in Table 2. FIG. 3 shows a graph in which the horizontal axis represents a frequency (GHz) and the vertical axis represents a dielectric loss tangent.

**[Table 2]**

| | | 10 GHz | 40 GHz | 60 GHz | 80 GHz | δ80/δ10 |
|---|---|---|---|---|---|---|
| Example 1 | PMPS-PPO-1 | 0.00169 | 0.00169 | 0.00179 | 0.00184 | 1.09 |
| Comparative Example 1 | PPS | 0.00253 | 0.00333 | Not measured | 0.00402 | 1.58 |
| Comparative Example 2 | PPO | 0.00160 | 0.00239 | Not measured | 0.00296 | 1.85 |
| Comparative Example 3 | PPO/3,5-dimethyl PPS resin = 1/1 | 0.00119 | 0.00171 | 0.00198 | 0.00227 | 1.91 |
| Reference Example | 3,5-Dimethyl PPS resin | 0.00087 | 0.00152 | Not measured | 0.00213 | 2.45 |

As shown in Table 1, the phenylene sulfide-phenylene oxide copolymers of Examples 1 and 2 both have a dielectric loss tangent of less than 0.002 at 10 GHz, and can achieve a low dielectric loss tangent. In addition, the glass transition temperature Tg exceeds 140°C, and the copolymers have heat resistance.

As shown in Table 2 and FIG. 3, in the molded article of the phenylene sulfide/phenylene oxide copolymer of Example 1, the ratio tan δ₈₀/tan δ₁₀ of the dielectric loss tangent tan δ₈₀ at 80 GHz to the dielectric loss tangent tan δ₁₀ at 10 GHz is 1.5 or less, and the additional effect that the dielectric loss tangent is less likely to be higher even at a higher frequency is obtained.

### Industrial Applicability

The phenylene sulfide-phenylene oxide copolymer according to the present embodiment can achieve a low dielectric loss tangent, and thus can be used in various applications requiring high-speed communication, and has industrial applicability.

## Claims

1. A phenylene sulfide-phenylene oxide copolymer for a wiring board, the phenylene sulfide-phenylene oxide copolymer comprising a constituent unit represented by Formula (I):
-Ph¹-O-Ph²-S- (I)
where Ph¹ and Ph² each independently represent a phenylene group optionally having a substituent.

2. The phenylene sulfide-phenylene oxide copolymer according to claim 1, wherein in Formula (I), at least one of Ph¹ or Ph² has one or more substituents.

3. The phenylene sulfide-phenylene oxide copolymer according to claim 1 or 2, wherein the constituent unit represented by Formula (I) comprises a constituent unit represented by Formula (II): 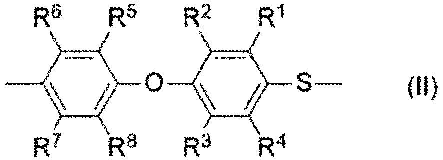 where
R¹, R², R³, R⁴, R⁵, R⁶, R⁷ and R⁸ are each independently H, an alkyl group, an alkoxy group, an alkenyl group, or an aryl group,
one or more of R¹, R², R³, and R⁴ are an alkyl group, an alkoxy group, an alkenyl group, or an aryl group, and/or
one or more of R⁵, R⁶, R⁷, and R⁸ are an alkyl group, an alkoxy group, an alkenyl group or an aryl group.

4. The phenylene sulfide-phenylene oxide copolymer according to claim 3, wherein
in Formula (II),
one or more of R¹, R², R³, and R⁴ are an alkyl group, an alkoxy group, an alkenyl group, or an aryl group, and
one or more of R⁵, R⁶, R⁷, and R⁸ are an alkyl group, an alkoxy group, an alkenyl group, or an aryl group.

5. The phenylene sulfide-phenylene oxide copolymer according to claim 1 or 2, wherein a content of the constituent unit represented by Formula (I) is 60 mol% or more with respect to all constituent units.

6. The phenylene sulfide-phenylene oxide copolymer according to claim 1 or 2, wherein a dielectric loss tangent at 10 GHz of the phenylene sulfide-phenylene oxide copolymer is less than 0.002.

7. The phenylene sulfide-phenylene oxide copolymer according to claim 1 or 2, wherein a dielectric loss tangent at 80 GHz of the phenylene sulfide-phenylene oxide copolymer is less than 0.002.

8. The phenylene sulfide-phenylene oxide copolymer according to claim 1 or 2, wherein a ratio tan δ₈₀/tan δ₁₀ of a dielectric loss tangent tan δ₈₀ at 80 GHz to a dielectric loss tangent tan δ₁₀ at 10 GHz is 1.5 or less.

9. A resin composition comprising the phenylene sulfide-phenylene oxide copolymer described in claim 1.

10. A phenylene sulfide-phenylene oxide copolymer comprising a constituent unit represented by Formula (Ia):
-Ph^{1a}-O-Ph^{2a}-S- (Ia)
where
Ph^{1a} and Ph^{2a} each independently represent a phenylene group optionally having a substituent, and
Ph^{1a} and Ph^{2a} each have one or more substituents.

11. The phenylene sulfide-phenylene oxide copolymer according to claim 10, wherein the constituent unit represented by Formula (Ia) comprises a constituent unit represented by Formula (IIa): 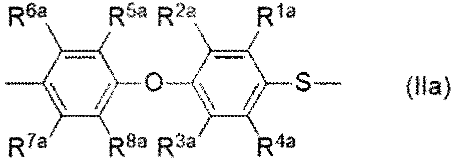 where
R^{1a}, R^{2a}, R^{3a}, R^{4a}, R^{5a} , R^{6a}, R^{7a}, and R^{8a} are each independently H, an alkyl group, an alkoxy group, an alkenyl group, or an aryl group,
one or more of R^{1a}, R^{2a}, R^{3a}, and R^{4a} are an alkyl group, an alkoxy group, an alkenyl group, or an aryl group, and
one or more of R^{5a}, R^{6a}, R^{7a}, and R^{8a} are an alkyl group, an alkoxy group, an alkenyl group, or an aryl group.

12. The phenylene sulfide-phenylene oxide copolymer according to claim 11, wherein
in Formula (IIa),
R^{2a}, R^{3a}, R^{6a} and R^{7a} are each independently an alkyl group, an alkoxy group, an alkenyl group, or an aryl group, or
R^{1a}, R^{4a}, R^{5a}, and R^{8a} are each independently an alkyl group, an alkoxy group, an alkenyl group, or an aryl group.

13. The phenylene sulfide-phenylene oxide copolymer according to claim 10 or 11, wherein a content of the constituent unit represented by Formula (Ia) is 60 mol% or more with respect to all constituent units.

14. The phenylene sulfide-phenylene oxide copolymer according to claim 10 or 11, wherein a ratio tan δ₈₀/tan δ₁₀ of a dielectric loss tangent tan δ₈₀ at 80 GHz to a dielectric loss tangent tan δ₁₀ at 10 GHz is 1.5 or less.

15. A resin composition comprising the phenylene sulfide-phenylene oxide copolymer described in claim 10.

16. A wiring board comprising the phenylene sulfide-phenylene oxide copolymer described in claim 1, 2, 10, or 11, or the resin composition described in claim 9 or 15.

17. A printed wiring board comprising:
the wiring board described in claim 16; and
an electronic component.

18. A wiring board material comprising the phenylene sulfide-phenylene oxide copolymer described in claim 1, 2, 10, or 11, or the resin composition described in claim 9 or 15.

19. The wiring board material according to claim 18, being a varnish, an interlayer insulating material, a prepreg, a metal-clad laminate, or a substrate.

20. A compatibilizer comprising the phenylene sulfide-phenylene oxide copolymer described in claim 1, 2, 10, or 11, or the resin composition described in claim 15.

21. The compatibilizer according to claim 20, being for a resin composition comprising a polyarylene sulfide resin and a polyarylene ether resin.
